# EUROPEAN PATENT APPLICATION

(11) **EP 4 836 271 A1**
(43) Date of publication of application: **04.11.2026**
(21) Application number: 24917257.8
(22) Date of filing: 13.12.2024
(51) Int. Cl.: H02M 3/157, H02M 1/00, H02M 3/00, H02M 1/08

(54) **CONTROL CIRCUIT FOR CONVERTER AND ELECTRONIC DEVICE**

(30) Priority: 12.01.2024 KR 20240005721; 23.01.2024 KR 20240010533
(71) Applicant: Samsung Electronics Co., Ltd., Suwon-si, Gyeonggi-do 16677 (KR)
(72) Inventor: YEON, Cheolo, Suwon-si Gyeonggi-do 16677 (KR); LEE, Juyoung, Suwon-si Gyeonggi-do 16677 (KR); LIM, Geonhui, Suwon-si Gyeonggi-do 16677 (KR)
(74) Representative: Gulde & Partner
(86) International application number: PCT/KR2024/096954
(87) International publication number: WO 2025/150768

(57) **Abstract**

This control circuit for a direct current (DC) to DC converter may include a pulse width modulation (PWM) controller for generating a PWM signal applied to a gate of a transistor in the DC to DC converter. The control circuit may include a lumped element connected to an adjustment pin of the PWM controller for adjusting a switching frequency of the PWM signal which controls a time when the gate is driven. The control circuit may include a first resistor to which a driving voltage of the PWM controller is applied. The control circuit may include a diode connected to the first resistor. The control circuit may comprise: a capacitor arranged in parallel between the diode and the adjustment pin; and a second resistor for discharging the capacitor.

## Description

### [Technical Field]

The following descriptions relate to a control circuit for a converter and an electronic device.

### [Background Art]

An electronic device may obtain power from an outside of the electronic device. For example, the power may include a voltage. For example, the electronic device may perform conversion of the power obtained from the outside. For example, the electronic device may include a converter for converting the power. For example, the electronic device may use the power converted an inside of the electronic device.

### [Disclosure]

### [Technical Solution]

A control circuit for a direct current (DC)-DC converter may comprise a pulse width modulation (PWM) controller for generating a PWM signal applied to a gate of a transistor in the DC-DC converter. The control circuit may comprise a lumped element connected to an adjusting pin of the PWM controller for adjusting a switching frequency of the PWM signal controlling a time when the gate is driven. The control circuit may comprise a first resistor to which a driving voltage of the PWM controller is applied. The control circuit may comprise a diode connected to the first resistor. The control circuit may comprise a capacitor and a second resistor for discharging of the capacitor that are disposed in parallel between the diode and the adjusting pin.

An electronic device may comprise a direct current (DC)-DC converter. The electronic device may comprise an electronic component to which a voltage converted by the DC-DC converter is applied. The electronic device may comprise a pulse width modulation (PWM) controller for generating a PWM signal applied to a gate of a transistor in the DC-DC converter. The electronic device may comprise a lumped element connected to an adjusting pin of the PWM controller for adjusting a switching frequency of the PWM signal controlling a time when the gate is driven. The electronic device may comprise a first resistor to which a driving voltage of the PWM controller is applied. The electronic device may comprise a diode connected to the first resistor. The electronic device may comprise a capacitor and a second resistor for discharging of the capacitor that are disposed in parallel between the diode and the adjusting pin.

### [Description of the Drawings]

FIG. 1 illustrates an example of a wireless communication system.
FIG. 2 illustrates an example of network entities according to a distributed deployment.
FIG. 3 illustrates an example of an electronic device converting power supplied from an outside.
FIG. 4A and FIG. 4B illustrate examples of a direct current (DC)-DC converter of an electronic device.
FIG. 5A illustrates an example of a pulse width modulation (PWM) controller for controlling a DC-DC converter and an output signal of the PWM controller.
FIG. 5B illustrates an example of a pulse frequency modulation (PFM) controller for controlling a DC-DC converter and an output signal of the PFM controller.
FIG. 6 illustrates an example of a control circuit including a switching circuit for adjusting a switching frequency of an output signal of a PWM controller.
FIG. 7 illustrates an example of a control circuit including a voltage dividing circuit for adjusting an over current protection (OCP) level of a PWM controller.
FIG. 8 illustrates an example of a control circuit including a discharging circuit of a capacitor for adjusting a switching frequency.
FIG. 9A and FIG. 9B illustrate examples of a control circuit including a protection circuit.
FIG. 10 illustrates an example of a control circuit connected to a DC-DC converter.
FIG. 11A and FIG. 11B illustrate examples of a DC-DC converter including a damping circuit.

### [Mode for Invention]

Terms used in the present disclosure are used only to describe a specific embodiment, and may not be intended to limit a range of another embodiment. A singular expression may include a plural expression unless the context clearly means otherwise. Terms used herein, including a technical or a scientific term, may have the same meaning as those generally understood by a person with ordinary skill in the art described in the present disclosure. Among the terms used in the present disclosure, terms defined in a general dictionary may be interpreted as identical or similar meaning to the contextual meaning of the relevant technology and are not interpreted as ideal or excessively formal meaning unless explicitly defined in the present disclosure. In some cases, even terms defined in the present disclosure may not be interpreted to exclude embodiments of the present disclosure.

In various embodiments of the present disclosure described below, a hardware approach will be described as an example. However, since the various embodiments of the present disclosure include technology that uses both hardware and software, the various embodiments of the present disclosure do not exclude a software-based approach.

Terms referring to a component of an electronic device (e.g., circuit, element, module, assembly, component), terms referring to a signal (e.g., signal, output signal, input signal), terms referring to a connection portion (e.g., pin, end, port, node), and the like, used in the following description, are exemplified for convenience of description. Therefore, the present disclosure is not limited to terms to be described below, and another term having an equivalent technical meaning may be used. In addition, a term such as '...unit', '...device', '...object', and '...structure', and the like used below may mean at least one shape structure or may mean a unit processing a function.

In addition, in the present disclosure, the term 'greater than' or 'less than' may be used to determine whether a particular condition is satisfied or fulfilled, but this is only a description to express an example and does not exclude description of 'greater than or equal to' or 'less than or equal to'. A condition described as 'greater than or equal to ' may be replaced with 'greater than', a condition described as 'less than or equal to' may be replaced with 'less than', and a condition described as ' greater than or equal to and less than' may be replaced with 'greater than and less than or equal to'. In addition, hereinafter, 'A' to 'B' refers to at least one of elements from A (including A) to B (including B). Hereinafter, 'C' and/or 'D' means including at least one of 'C' or 'D', that is, {'C', 'D', and 'C' and 'D'}.

The present disclosure describes embodiments using terms used in some communication standards (e.g., 3rd Generation Partnership Project (3GPP)), but this is merely an example for description. Embodiments of the present disclosure may also be applied to other communication and broadcasting systems.

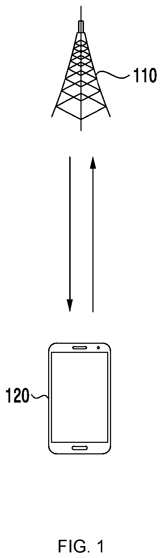

FIG. 1 illustrates an example of a wireless communication system.

Referring to FIG. 1, FIG. 1 illustrates a base station 110 and a terminal 120 as a portion of nodes that utilize a wireless channel in a wireless communication system. FIG. 1 illustrates only one base station, but a wireless communication system may further include another base station that is identical or similar to the base station 110.

The base station 110 is a network infrastructure that provides wireless access to the terminal 120. The base station 110 has coverage defined based on a distance at which a signal may be transmitted. In addition to 'base station', the base station 110 may be referred to as an 'access point (AP)', 'eNodeB (eNB)', '5th generation node', 'next generation nodeB (gNB)', 'wireless point', 'transmission/reception point (TRP)' or other terms having equivalent technical meanings.

The terminal 120, which is a device used by a user, performs communication with the base station 110 through a wireless channel. A link from the base station 110 to the terminal 120 is referred to as a downlink (DL), and a link from the terminal 120 to the base station 110 is referred to as an uplink (UL). In addition, although not illustrated in FIG. 1, the terminal 120 and another terminal may perform communication with each other through a wireless channel. At this time, a link (device-to-device link (D2D)) between the terminal 120 and the other terminal is referred to as a sidelink, and the sidelink may be used interchangeably with a PC5 interface. In some other embodiments, the terminal 120 may be operated without the user's involvement. According to an embodiment, the terminal 120, which is a device performing machine type communication (MTC), may not be carried by the user. Additionally, according to an embodiment, the terminal 120 may be a narrowband (NB)-internet of things (IoT) device.

In addition to 'terminal', the terminal 120 may also be referred to as 'user equipment (UE) ', 'customer premises equipment, (CPE) ', 'mobile station', 'subscriber station', 'remote terminal', 'wireless terminal', 'electronic device', 'user device', or other terms having equivalent technical meanings.

The base station 110 may perform beamforming with the terminal 120. The base station 110 and the terminal 120 may transmit and receive a wireless signal in a relatively low frequency band (e.g., frequency range 1 (FR 1) of NR). In addition, the base station 110 and the terminal 120 may transmit and receive a wireless signal in a relatively high frequency band (e.g., FR 2 (or FR 2-1, FR 2-2, FR 2-3) or FR 3), and a mmWave band (e.g., 28GHz, 30GHz, 38GHz, 60GHz). The base station 110 and the terminal 120 may perform beamforming to improve a channel gain. Herein, the beamforming may include transmission beamforming and reception beamforming. The base station 110 and the terminal 120 may provide directivity to a transmission signal or a reception signal. To this end, the base station 110 and the terminal 120 may select serving beams through a beam search or beam management procedure. After the serving beams are selected, subsequent communication may be performed through a resource in a QCL relationship with the resource transmitting the serving beams.

If large-scale characteristics of a channel carrying a symbol on a first antenna port may be inferred from a channel carrying a symbol on a second antenna port, the first antenna port and the second antenna port may be evaluated to be in the QCL relationship. For example, large-scale characteristics may include at least one of a delay spread, a Doppler spread, a Doppler shift, an average gain, an average delay, and a spatial receiver parameter.

Although FIG. 1 describes that both the base station 110 and the terminal 120 perform beamforming, the embodiments of the present disclosure are not necessarily limited thereto. In some embodiments, the terminal may or may not perform beamforming. In addition, the base station may or may not perform beamforming. That is, either only one of the base station and the terminal may perform beamforming, or neither the base station nor the terminal may perform beamforming.

In the present disclosure, a beam refers to a spatial flow of a signal in a wireless channel, and is formed by one or more antennas (or antenna elements), and this formation process may be referred to as beamforming. Beamforming may include at least one of analog beamforming or digital beamforming (e.g., precoding). A reference signal transmitted based on beamforming may include, for example, a demodulation-reference signal (DM-RS), a channel state information-reference signal (CSI-RS), a synchronization signal/physical broadcast channel (SS/PBCH), and a sounding reference signal (SRS). In addition, an IE such as CSI-RS resource or SRS-resource may be used as a configuration for each reference signal, and this configuration may include information associated with the beam. The information associated with the beam may mean whether a corresponding configuration (e.g., CSI-RS resource) uses the same spatial domain filter as another configuration (e.g., another CSI-RS resource within the same CSI-RS resource set) or a different spatial domain filter, or which reference signal it is quasi-co-located (QCL) with, and if so, what type it is (e.g., QCL type A, B, C, D).

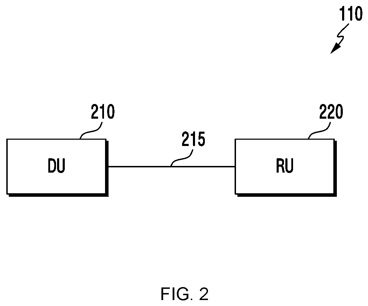

Conventionally, in a communication system in which a cell radius of a base station is relatively large, each base station was installed such that each base station includes functions of a digital processing unit (or a distributed unit (DU)) and a radio frequency (RF) processing unit (RF processing unit, or a radio unit (RU)). However, as a high frequency band is used in 4th generation (4G) and/or a subsequent communication system (e.g., 5G) and cell coverage of a base station becomes small, the number of base stations for covering a specific area has increased. A burden of installation costs of an operator for installing base stations has also increased. In order to minimize installation costs of a base station, a structure has been proposed in which a DU and an RU of the base station are separated, one or more RUs are connected to one DU through a wired network, and one or more RUs geographically distributed to cover a specific area are disposed. Hereinafter, a disposition structure and expansion examples of the base station according to various embodiments of the present disclosure are described through FIG. 2.

FIG. 2 illustrates an example of network entities according to a distributed deployment.

For example, the network entities may include a digital unit (DU) 210 and a radio unit (RU) 220 (or a massive multiple input multiple output unit (MMU)). For example, the network entities may be connected through a fronthaul. Unlike a backhaul between a base station and a core network, the fronthaul refers to entities (e.g., the DU 210 and the RU 220) between a wireless LAN and the base station. In FIG. 2, The DU 210 illustrates an example of a fronthaul structure between one RU 220, but this is only for convenience of description and the present disclosure is not limited thereto. In other words, an embodiment of the present disclosure may also be applied to a fronthaul structure between one DU and a plurality of RUs. For example, an embodiment of the present disclosure may be applied to a fronthaul structure between one DU and two RUs. In addition, an embodiment of the present disclosure may be applied to a fronthaul structure between one DU and three RUs.

Referring to FIG. 2, a base station 110 may include the DU 210 and the RU 220. A fronthaul 215 between the DU 210 and the RU 220 may be operated through an Fx interface. For operation of the fronthaul 215, for example, an interface such as enhanced common public radio interface (eCPRI) and radio over ethernet (ROE) may be used. According to an implementation example, in addition to the DU, the DU 210 may be referred to as a baseband unit (BBU), a digital BBU, a baseband digital unit, a processing unit, digital processing circuitry, baseband processing circuitry, a baseband processing unit, and/or an equivalent technical term. According to an implementation example, in addition to the RU, the RU 220 may be referred to as a remote unit, a radio demote head (RRH), radio processing circuitry, a radio processing unit, an antenna integrated radio, an air radio device, an air scale communication device, a radio device, a radio communication device, and/or an equivalent technical term. In addition, according to an implementation example, a network entity connected to the DU 210 is described as the RU 220 in the present disclosure, but the massive multiple input multiple output unit (MMU) may be connected to the DU 210 and used instead of the RU 220.

As a communication technology develops, mobile data traffic increases, and accordingly, a bandwidth requirement required in a fronthaul between a digital unit and a radio unit has greatly increased. In a deployment such as a centralized/cloud radio access network (C-RAN), the DU 210 may be implemented to perform functions for a packet data convergence protocol (PDCP), a radio link control (RLC), a media access control (MAC), and a physical (PHY), and the RU 220 may be implemented to further perform functions for the PHY layer in addition to a radio frequency (RF) function.

The DU 210 may be responsible for an upper layer function of a wireless network. For example, the DU 210 may perform a function of the MAC layer and a portion of the PHY layer. Herein, the portion of the PHY layer refers to being performed at a relatively higher stage among the functions of the PHY layer, and, as an example, may include channel encoding (or channel decoding), scrambling (or descrambling), modulation (or demodulation), and layer mapping (or layer demapping). According to an embodiment, in a case that the DU 210 conforms to an O-RAN standard, the DU 210 may be referred to as an O-DU. The DU 210 may be replaced with and represented as a first network entity for a base station (e.g., gNB) in embodiments of the present disclosure as necessary.

The RU 220 may be responsible for lower layer functions of the wireless network. For example, the RU 220 may perform a portion of the PHY layer and an RF function. Herein, the portion of the PHY layer refers to being performed at a relatively lower stage than the DU 210 among the functions of the PHY layer, and, as an example, may include iFFT transformation (or FFT transformation), CP insertion (CP removal), and digital beamforming. The RU 220 may be referred to as 'an access unit (AU)', 'an access point (AP)', 'a transmission/reception point (TRP)', 'a remote radio head (RRH)', 'a radio unit (RU)', or another term having an equivalent technical meaning. According to an embodiment, in a case that the RU 220 conforms to the O-RAN standard, the RU 220 may be referred to as an O-RU. The RU 220 may be replaced with and represented as a second network entity for the base station (e.g., gNB) in embodiments of the present disclosure as necessary.

In FIG. 2, the base station 110 is described as including the DU 210 and the RU 220, but embodiments of the present disclosure are not limited thereto. The base station according to embodiments may be implemented as a distributed deployment according to a centralized unit (CU) configured to perform functions of upper layers (e.g., a packet data convergence protocol (PDCP), or a radio resource control (RRC)) of an access network and a distributed unit (DU) configured to perform functions of lower layers. As an example, the digital unit (DU) 210 may be implemented by being separated into a centralized unit (CU) and a distributed unit (DU). Between the core network (e.g., a 5G core (5GC) or a next generation core (NGC)) and a radio network (RAN), the base station may be implemented in a structure in which a centralized unit (CU), a distributed unit (DU), and a radio unit (RU) are disposed in order. An interface between the centralized unit (CU) and the distributed unit (DU) may be referred to as an F1 interface.

The centralized unit (CU) may be responsible for functions of higher layers than a distributed unit (DU) by being connected to one or more distributed units (DUs). For example, the CU may be responsible for functions of a radio resource control (RRC) layer and a packet data convergence protocol (PDCP) layer, and the DU and the RU may be responsible for functions of lower layers. The DU may perform a portion of functions (high PHY) of the radio link control (RLC) layer, the media access control (MAC) layer, and the physical (PHY) layer, and the RU may be responsible for remaining functions (low PHY) of the PHY layer. In addition, as an example, the digital unit (DU) may be included in the distributed unit (DU) according to a distributed deployment implementation of the base station. Hereinafter, unless otherwise defined, operations of a digital unit (DU) and an RU are described, but various embodiments of the present disclosure may be applied to both a base station deployment including the CU or a deployment in which the DU is directly connected to the core network (i.e., the CU and the DU are implemented by being integrated into a base station (e.g., an NG-RAN node) that is one entity).

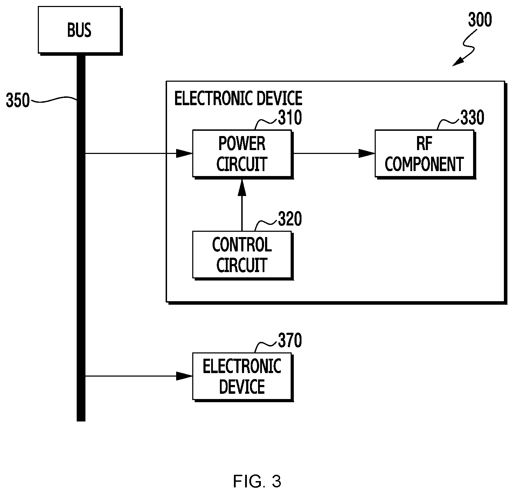

FIG. 3 illustrates an example of an electronic device converting power supplied from an outside.

For example, an electronic device 300 of FIG. 3 may be an example of the base station 110 of FIG. 1, the DU 210 of FIG. 2, or the RU 220 of FIG. 2. However, an embodiment of the present disclosure is not limited thereto. For example, the electronic device 300 may include a massive multiple-input multiple-output unit (MMU). For example, the electronic device 300 may indicate an example of communication equipment that obtains a voltage in a specific range from the outside, converts the obtained voltage, and uses the converted voltage. For example, the communication equipment may include a server (or a server device).

For example, the MMU may be an electronic device including at least a portion of functions of a DU 210 and a function of an RU 220. For example, the RU 220 may perform amplification and radiation for a digital signal processed from the DU 210. For example, the MMU may perform processing on a digital signal obtained from the DU 210 and perform amplification and radiation of the processed signal. For example, the MMU may include a greater number of antenna elements than the RU 220. For example, the RU 220 may include four antenna elements (or 4transmission 4reception (4T4R)) or eight antenna elements (or 8T8R). The MMU may include 32 antenna elements (or 32T32R) or 64 antenna elements (or 64T64R). However, the present disclosure is not limited thereto. For example, the number of antenna elements included in the RU 220 and the number of antenna elements included in the MMU may be changed. The MMU may operate a greater number of antenna elements than the RU 220 since power consumption of each antenna element is relatively low compared with the RU 220. Hereinafter, for convenience of description, a case in which the electronic device 300 is the MMU or the RU 220 is described as an example, but the present disclosure is not limited thereto.

Referring to FIG. 3, the electronic device 300 may be connected to a bus 350. For example, the bus 350 may indicate a structure or a component for supplying power to a plurality of electronic devices 300 and 370. For example, the bus 350 may be implemented as a line. In FIG. 3, two electronic devices 300 and 370 are illustrated as being connected to the bus 350, but the present disclosure is not limited thereto. For example, the bus 350 may be connected to one electronic device or connected to three or more electronic devices.

For example, the power supplied by the bus 350 may include a voltage. For example, the power may be a DC voltage in a specific range. For example, the specific range may include -36 voltage (V) to -60 V. The example is merely exemplary for convenience of description, and the present disclosure is not limited thereto. For example, the specific range may be defined by an operator using the electronic device 300 and the bus 350. In other words, the bus 350 may be designed to provide the specific range considering a margin, in consideration of a point that the power used for each operator may be changed.

According to an embodiment, the electronic device 300 may include a power circuit 310, a control circuit 320, and a radio frequency (RF) component 330. In FIG. 3, a case in which one RF component 330 connected to the power circuit 310 is illustrated, but the present disclosure is not limited thereto. For example, the electronic device 300 may include a plurality of RF components connected to the power circuit 310. In addition, in FIG. 3, as described above, in a case that the electronic device 300 is the MMU or the RU 220, a case in which an electronic part connected to the power circuit 310 is the RF component 330 is illustrated, but the present disclosure is not limited thereto. For example, the electronic device 300 may include an electronic component connected to the power circuit 310 and for using power provided from the power circuit 310.

According to an embodiment, the power circuit 310 of the electronic device 300 may include a DC-DC converter. For example, the DC-DC converter may use the DC voltage obtained from the bus 350 as an input voltage and convert the input voltage into a voltage (or an output voltage) used by the RF component 330. In other words, the DC-DC converter may output the output voltage converted from the DC voltage obtained from the bus 350. For example, the output voltage may include a specific voltage (e.g., -48 V) that may be used by the RF component 330. For example, the DC-DC converter of the power circuit 310 may be referred to as an isolated bus converter or a resonant converter. For example, the resonant converter may include an LLC converter or a cap-isolation converter.

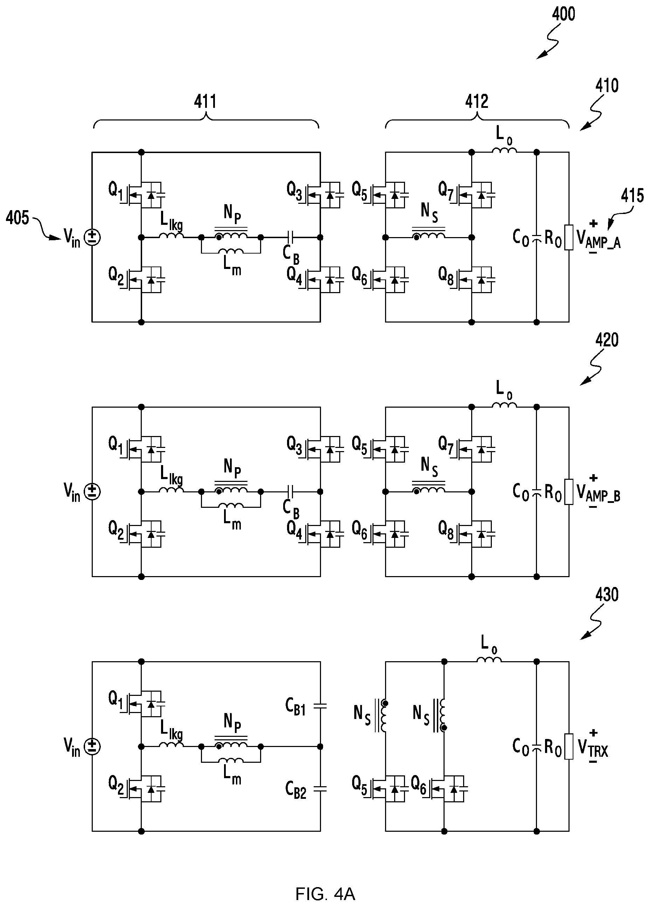

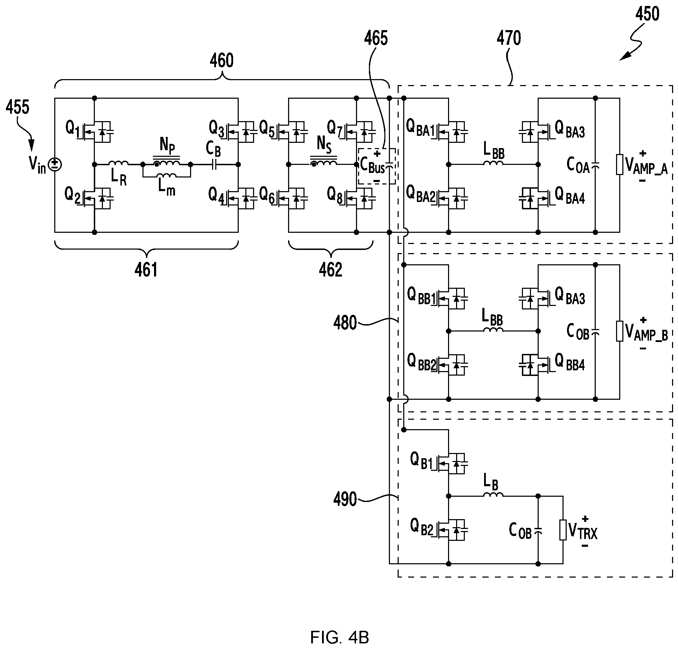

For example, the DC-DC converter may have a 1 stage structure to generate the output voltage from the input voltage obtained from the bus 350. A specific example of the DC-DC converter having the 1 stage structure is described below in FIG. 4A. Alternatively, the DC-DC converter may have a 2 stage structure to generate the output voltage from the input voltage obtained from the bus 350. A specific example of the DC-DC converter having the 2 stage structure is described below in FIG. 4B.

In the example, a case in which the power circuit 310 includes the DC-DC converter is described, but the present disclosure is not limited thereto. For example, the power circuit 310 may include not only the DC-DC converter but also a component for controlling power.

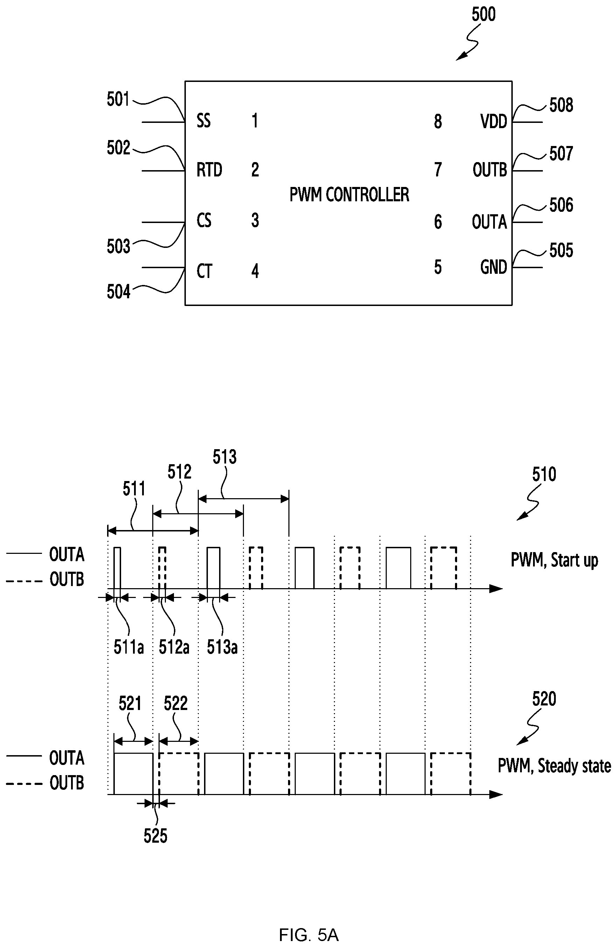

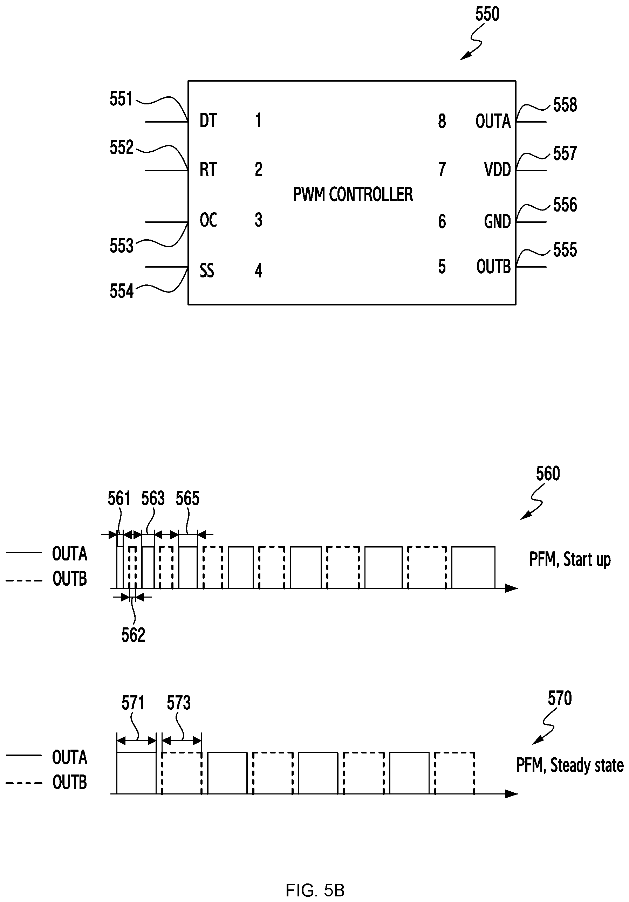

According to an embodiment, the electronic device 300 may include the control circuit 320 for controlling the power circuit 310. For example, the control circuit 320 may generate a signal for controlling an operation of the power circuit 310. For example, the control circuit 320 may include a pulse width modulation (PWM) controller or a pulse frequency modulation (PFM) controller. For example, in a case that the control circuit 320 is the PWM controller, the signal may be referred to as a PWM signal. A specific example of the control circuit 320 that is the PWM controller and the PWM signal generated (or output) from the control circuit 320 is described below in FIG. 5A. For example, in a case that the control circuit 320 is the PFM controller, the signal may be referred to as a PFM signal. A specific example of the control circuit 320 that is the PFM controller and the PFM signal generated (or output) from the control circuit 320 is described below in FIG. 5B.

For example, the control circuit 320 may cause the operation of the power circuit 310 by providing the signal to the power circuit 310. For example, in a case that the power circuit 310 is the DC-DC converter, the signal may be provided (or input) to a gate of a transistor of the DC-DC converter. For example, as the signal is provided to the gate in the transistor of the DC-DC converter, a time when the gate is driven may be controlled. The transistor may include a field effect transistor (FET). However, the present disclosure is not limited thereto.

According to an embodiment, the RF component 330 of the electronic device 300 may include at least one of a power amplifier, a radio frequency integrated circuit (RFIC), or a transceiver (e.g., an RF front end, a radiator (or an antenna element)). However, the present disclosure is not limited thereto. The RF component 330 may indicate an electronic part using the output voltage provided from the power circuit 310.

Referring to the above, since an input voltage in which the electronic device 300 obtains may be different for each operator, the specific range of the input voltage that may be converted by the power circuit 310 may be designed considering a margin. For example, when an emergency battery is used or a battery for a power outage is used at a time of a power outage, even if a low input voltage (e.g., -36 V) is used, the electronic device 300 needs to be normally operated. Accordingly, the electronic device 300 requires the power circuit 310 having a wide input range and capable of maintaining high conversion efficiency even at a low input.

In addition, the electronic device 300 requires the power circuit 310 satisfying a minimum isolation condition. As described above, the power circuit 310 uses a low DC voltage of 100 V or less as an input, but a rectifier for converting an AC voltage obtained from the outside into the DC voltage may be required. In this case, for compatibility between the electronic device 300 and the rectifier, the power circuit 310 satisfying the minimum isolation condition is needed. For example, the minimum isolation condition may indicate Functional isolation, which is an isolation standard with the rectifier, and an isolation condition of 1 kV or more. The DC-DC converter having the 1 stage or the 2 stage structure designed considering the isolation standard is described in detail below through FIG. 4A and FIG. 4B.

FIG. 4A and FIG. 4B illustrate examples of a direct current (DC)-DC converter of an electronic device.

FIG. 4A illustrates an example in which the power circuit 310 in the electronic device 300 of FIG. 3 is a DC-DC converter having a 1 stage structure. FIG. 4B illustrates an example in which the power circuit 310 in the electronic device 300 of FIG. 3 is a DC-DC converter having a 2 stage structure.

Referring to FIG. 4A, the electronic device 300 may include DC-DC converters 400 having the 1 stage structure. For example, the electronic device 300 may include a DC-DC converter 410 for a first RF component, a DC-DC converter 420 for a second RF component, and a DC-DC converter 430 for a third RF component. The DC-DC converter illustrated in FIG. 4A is merely for convenience of description, and the present disclosure is not limited thereto. For example, elements included in each of the DC-DC converters 400, a disposition of the elements, the number of the elements, and the number of the DC-DC converters 400 may be changed.

Referring to FIG. 4A, the DC-DC converter 410 may include a transformer for converting an input voltage 405 of power into an output voltage 415 applied to an output resistor Ro. For example, the transformer may include a first portion 411 and a second portion 412. For example, the first portion 411 may be referred to as an input portion (or an input part). For example, the second portion 412 may be referred to as an output portion (or an output part). For example, based on a winding ratio NP:NS between the first portion 411 and the second portion 412, the output voltage 415 converted from the input voltage 405 may be determined. For example, the output voltage 415 may be input (or transferred) to the first RF component (e.g., a first power amplifier AMP_A).

The description of the DC-DC converter 410 as described above may be substantially identically applied to the DC-DC converter 420 for the second RF component (e.g., a second power amplifier AMP_B) or the DC-DC converter 430 for the third RF component (e.g., a transceiver TRX). Hereinafter, the same description is omitted.

Referring to the above, the electronic device 300 including the DC-DC converters 400 having the 1 stage structure designed to satisfy an isolation condition may output relatively high efficiency through a relatively simple structure. However, the electronic device 300 such as an RU 220 or the MMU requires high-capacity power design, and the DC-DC converters 400 designed in parallel may be used due to a stress limitation (or an allowable voltage) of elements in the DC-DC converters while supplying the high-capacity power. In a case that the electronic device 300 includes the DC-DC converters 400, since each DC-DC converter includes a transformer, a size of the electronic device 300 (or the power circuit 310) may increase and a production cost may be increased. In addition, since a 1 stage signal and a 2 stage signal exist in the electronic device 300 (or the power circuit 310) to implement an off sequence required by a system, the size of the electronic device 300 (or the power circuit 310) may be increased. In order to solve the problem as described above, the electronic device 300 may use a DC-DC converter having the 2 stage structure. For specific details related thereto, FIG. 4B may be referred to below.

Referring to FIG. 4B, the electronic device 300 may include a DC-DC converter 450 having the 2 stage structure. For example, the DC-DC converter 450 of the electronic device 300 may include a 1 stage circuit 460 including a transformer for providing an output voltage to a first circuit 470, a second circuit 480, and a third circuit 490, and a 2 stage circuit including the first circuit 470, the second circuit 480, and the third circuit 490. For example, the 2 stage circuit may include the first circuit 470 for a first RF component, the second circuit 480 for a second RF component, and the third circuit 490 for a third RF component. The DC-DC converter 450 illustrated in FIG. 4B is merely for convenience of description, and the present disclosure is not limited thereto. For example, elements included in the DC-DC converter 450, a disposition of the elements, the number of the elements, and the number of the DC-DC converters 400 may be changed.

Referring to FIG. 4B, the 1 stage circuit 460 of the DC-DC converter 450 may include a transformer for converting an input voltage 455 of power into an output voltage 465 applied to a capacitor CBus. For example, the transformer may include a first portion 461 and a second portion 462. For example, the first portion 461 may be referred to as an input portion (or an input part). For example, the second portion 462 may be referred to as an output portion (or an output part). For example, based on a winding ratio NP:NS between the first portion 461 and the second portion 462, the output voltage 455 converted from the input voltage 455 may be determined. For example, the output voltage 465 may be input (or transferred) to the first RF component (e.g., a first power amplifier AMP_A) through the first circuit 470, input (or transferred) to the second RF component (e.g., a second power amplifier AMP_B) through the second circuit 480, and input (or transferred) to the third RF component (e.g., a transceiver TRX) through the third circuit 490.

Referring to the above, by using the DC-DC converter 450 including the 1 stage circuit 460 for converting the input voltage 455 and the 2 stage circuit for distributing the output voltage 465, the electronic device 300 (or the power circuit 310) may satisfy the isolation condition, and, at the same time, the size of the electronic device 300 (or the power circuit 310) may be reduced, and the production cost may be reduced.

A non-isolated converter may use dedicated analog ICs for controlling the non-isolated converter. However, in a case of an isolated bus converter, since various modifications may be required to meet user requirements according to relatively few applications (or use environments) and a relatively simple control structure, an dedicated analog IC suitable for the isolated bus converter may hardly exist. In addition, the existing dedicated analog IC uses a PWM-based duty control method. In a case of controlling the isolated bus converter in a PWM method, a voltage and a current stress of an element in the isolated bus converter may increase as a wide input range and an entire power range are covered. Accordingly, an advantage of the isolated bus converter (e.g., the DC-DC converter 450 of FIG. 4B) implemented in the 2 stage structure is lost. In addition, in a case that the isolated bus converter is a resonant bus converter using a resonance between a series capacitor and an inductor, control in a PFM method rather than the PWM-based duty control method may be required. For specific details of PWM-based control and PFM-based control, FIG. 5A and FIG. 5B may be referred to below.

FIG. 5A illustrates an example of a pulse width modulation (PWM) controller for controlling a DC-DC converter and an output signal of the PWM controller. FIG. 5B illustrates an example of a pulse frequency modulation (PFM) controller for controlling a DC-DC converter and an output signal of the PFM controller.

FIG. 5A illustrates an example of a plurality of pins included in a PWM controller 500, an example 510 of a PWM signal generated from the PWM controller 500 in a transient state interval of the PWM controller 500, and an example 520 of a PWM signal generated from the PWM controller 500 in a steady state interval of the PWM controller 500.

For example, the transient state interval may indicate an interval different from the steady state interval (or an interval until reaching the steady state interval). For example, the transient state interval may include a start-up interval. For example, the start-up interval may include a timing at which the PWM controller 500 starts to generate and output a PWM signal. For example, the start-up interval may be referred to as a start interval.

Referring to FIG. 5A, the PWM controller 500 may include a plurality of pins 501, 502, 503, 504, 505, 506, 507, and 508. In FIG. 5A, the PWM controller 500 is illustrated as including eight pins 501, 502, 503, 504, 505, 506, 507, and 508, but the present disclosure is not limited thereto. For example, the PWM controller 500 may include seven or fewer pins or nine or more pins. For example, the pin may be referred to as a port, an end, or a node. Or, for example, a disposition of pins included in the PWM controller 500 may be changed.

For example, the PWM controller 500 may include a pin 508 providing a driving voltage V_{DD} for driving of the PWM controller 500, and a pin 505 providing a ground of the PWM controller 500. For example, the PWM controller 500 may include a plurality of outputting pins 506 and 507. However, the present disclosure is not limited thereto. For example, the PWM controller 500 may include one outputting pin.

For example, the PWM controller 500 may include a pin 501 for gradually increasing a duty of PWM signals output in a designated interval. For example, the designated interval may be included in the start-up interval. For example, an operation of gradually increasing the duty in the start-up interval may be referred to as a soft start (SS) (SS function). For example, the pin 501 may be referred to as a controlling pin, a duty pin, or an SS pin.

For example, the PWM controller 500 may include a pin 502 for adjusting a dead-time between PWM signals OUTA and OUTB output from each of the outputting pins 506 and 507. For example, the pin 502 may be referred to as an RTD pin or a dead-time pin.

For example, the PWM controller 500 may include a pin 503 for sensing a current for over current protection (OCP). For example, the pin 503 of the PWM controller 500 may be used to sense a current passing through input power of a DC-DC converter (e.g., the DC-DC converter 450 of FIG. 4B) connected to the PWM controller 500. For example, the pin 503 may be referred to as a current sensing pin or a CS pin.

For example, the PWM controller 500 may include a pin 504 for adjusting a switching frequency (or a driving frequency) of each of the PWM signals OUTA and OUTB output from each of the outputting pins 506 and 507. For example, a lumped element (or a passive element) connected to the pin 504 of the PWM controller 500 may be used to determine the switching frequency of each of the PWM signals in the steady state interval of the PWM controller 500. For example, the lumped element may include at least one of a resistor or a capacitor. For example, the pin 504 may be referred to as a CT pin (e.g., in a case that the lumped element connected to the pin 504 is a capacitor), an RT pin (e.g., in a case that the lumped element connected to the pin 504 is a resistor), a CT/RT pin (e.g., in a case that the lumped element connected to the pin 504 is a capacitor and a resistor), or a switching frequency pin. For example, in a case that the lumped element is a capacitor, the capacitor may include multilayer ceramic capacitors (MLCC).

Referring to the example 510, the PWM controller 500 may gradually increase a duty of each of PWM signals output in the start-up interval. For example, the PWM signal OUTA may have a first value indicating ON during an interval 511a according to a first duty in a period 511. The PWM signal OUTA may have a second value indicating OFF in an interval other than the interval 511a according to the first duty in the period 511. For example, the PWM signal OUTB may have the first value indicating ON during an interval 512a according to the first duty in a period 512. The PWM signal OUTB may have the second value indicating OFF in an interval other than the interval 512a according to the first duty in the period 512. Thereafter, the PWM signal OUTA may have the first value indicating ON during an interval 513a according to a second duty having a value greater than the first duty in a period 513. The PWM signal OUTA may have the second value indicating OFF in an interval other than the interval 513a according to the second duty in the period 513. For example, each of the first duty and the second duty may be adjusted according to capacitance of a capacitor connected to the pin 501. In other words, the PMW controller 500 may gradually increase a duty such that a duty ratio becomes approximately 1:1 (or 50%) in the start-up interval according to the capacitance of the capacitor connected to the pin 501.

Referring to the example 520, the PWM controller 500 may determine a switching frequency in the steady state interval by using a capacitor (e.g., MLCC) connected to the pin 504. For example, the PWM controller 500 may generate and output a PWM signal OUTA in a period 521 and a PWM signal OUTB in a period 522 according to the switching frequency. For example, in the steady state interval, a gap 525 between the consecutive PWM signal OUTA and PWM signal OUTB may be referred to as a dead-time. For example, the gap 525 may be determined according to an RTD value determined based on the pin 502.

In a case of controlling a resonant bus converter, which is a DC-DC converter, through the PWM controller 500 based on a PWM method, an available switching frequency (or a switching frequency in the steady state interval) may be limited. In this case, since the resonant bus converter has a very small value of inductance of a series inductor, a relatively large stress may be applied to elements in the resonant bus converter due to a relatively large inrush current in the start-up interval. In addition, in a case of being used in communication equipment requiring a wide range (e.g., -36V to -60V) of an input voltage , as the DC-DC converter is designed based on an OCP level (or a reference value) for a relatively low voltage (e.g., -36V), an OCP level (or a reference value) for a relatively high voltage (e.g., -60V) is increased, and thus a stress of elements in the DC-DC converter may increase. In addition, although the PWM controller 500 supports auto recovery (or a hiccup function), a disadvantage in which OCP does not operate during the start-up interval (or soft start interval) may also exist.

FIG. 5B illustrates an example of a plurality of pins included in a PFM controller 550, an example 560 of a PFM signal generated from the PFM controller 550 in a transient state interval of the PFM controller 550, and an example 570 of a PFM signal generated from the PFM controller 550 in a steady state interval of the PFM controller 550.

For example, the transient state interval may indicate an interval different from the steady state interval (or an interval until reaching the steady state interval). For example, the transient state interval may include a start-up interval. For example, the start-up interval may include a timing at which the PFM controller 550 starts to generate and output a PFM signal. For example, the start-up interval may be referred to as a start interval.

Referring to FIG. 5B, the PFM controller 550 may include a plurality of pins 551, 552, 553, 554, 555, 556, 557, and 558. In FIG. 5A, the PFM controller 550 is illustrated as including eight pins 551, 552, 553, 554, 555, 556, 557, and 558, but the present disclosure is not limited thereto. For example, the PFM controller 550 may include seven or fewer pins or nine or more pins. For example, the pin may be referred to as a port, an end, or a node. Or, for example, a disposition of pins included in the PFM controller 550 may be changed.

For example, the PFM controller 550 may include a pin 557 providing a driving voltage V_{DD} for driving of the PFM controller 550, and a pin 556 providing a ground of the PFM controller 550. For example, the PFM controller 550 may include a plurality of outputting pins 555 and 558. However, the present disclosure is not limited thereto. For example, the PFM controller 550 may include one outputting pin.

For example, the PFM controller 500 may include a pin 501 for adjusting a dead-time between PFM signals OUTA and OUTB output from each of outputting pins 555 and 558. For example, the pin 501 may be referred to as a DT pin or a dead-time pin.

For example, the PFM controller 550 may include a pin 552 for adjusting a switching frequency of each of the PFM signals OUTA and OUTB output from each of the outputting pins 555 and 558. For example, a lumped element (or a passive element) connected to a pin 554 of the PFM controller 550 may be used to determine the switching frequency of each of the PFM signals. Unlike the PWM controller 500, the PFM controller 550 may change the switching frequency even outside the steady state interval. For example, the lumped element may include at least one of a resistor or a capacitor. For example, the pin 552 may be referred to as an RT pin or a switching frequency pin.

For example, the PFM controller 550 may include a pin 553 for sensing a current for over current protection (OCP). For example, the pin 553 of the PFM controller 550 may be used to sense a current passing through input power of a DC-DC converter (e.g., the DC-DC converter 450 of FIG. 4B) connected to the PFM controller 550. For example, the pin 553 may be referred to as a current sensing pin or an OC pin.

For example, the PFM controller 550 may include the pin 554 for gradually increasing a duty of PFM signals output in a designated interval. For example, the designated interval may be included in the start-up interval. For example, an operation of gradually increasing the duty in the start-up interval may be referred to as soft start (SS) (or SS function). For example, the pin 554 may be referred to as a controlling pin, a duty pin, or an SS pin.

Referring to the example 560, the PFM controller 550 may gradually increase a switching frequency of each of PFM signals output in the start-up interval. For example, the switching frequency may be inversely proportional to a period. For example, the PFM signal OUTA may have a first value indicating ON during an interval 561 according to a first period. For example, the PFM signal OUTA may have the first value indicating ON during an interval 563 according to a second period after the first period. For example, a length of the second period may be greater than a length of the first period. For example, the PFM signal OUTA may have the first value indicating ON during an interval 565 according to a third period after the second period. For example, a length of the third period may be greater than the length of the second period. For example, the PFM signal OUTB may have the first value indicating ON during an interval 562 according to a fourth period corresponding to the first period. The fourth period may indicate a period of OUTB having a length corresponding to the length of the first period of OUTA. Referring to the example 560, the PFM controller 550 may gradually increase a period of each of the PFM signals output, and, in this case, a duty of each of the PFM signals may be fixed. For example, a duty ratio may be 1:1 (or 50%).

Referring to the example 570, the PFM controller 550 may generate and output a signal having the lowest switching frequency (or the longest period) in the steady state interval. For example, the PFM controller 550 may generate and output a PFM signal OUTA in a period 571 according to the switching frequency and a PFM signal OUTB in a period 572 according to the switching frequency.

In a case of using the PFM controller 550, when connected to feedback, regulation of an output may be possible although in a narrow range. In addition, the PFM controller 550 may change a frequency in the start-up interval, but since the PFM controller 550 is used for an alternating current (AC)-DC converter, a range of a switching frequency that may be changed is limited, and the range may be changed according to a system. Accordingly, since a relatively large switching frequency required in the start-up interval may not be substantially provided, a relatively large inrush current may be generated even when the PFM controller 550 is used. In addition, in the start-up interval, a switching frequency in the steady state interval may be limitedly designed (e.g., less than 150 kHz) according to the range of the switching frequency. Similarly to the PWM controller 500, by an OCP level irrelevant to an input voltage, a stress of elements of a converter connected to the PFM controller 550 at a relatively high voltage may increase. Since a resonant PFM controller providing a high frequency is not a dedicated circuit for a bus converter, a production cost may increase due to adding a function for the bus converter or unused functions. In addition, as described above, since the PFM controller 550 is designed for an AC-DC converter, the PFM controller 550 for communication equipment and a resonant bus converter is required.

Referring to the above, analog control circuits for an isolated bus converter may include the PWM controller 500. In a case of using a resonant bus converter among the isolated bus converters, control in a PFM method of the PFM controller 550 may be required in at least a portion of intervals (e.g., the start-up interval). In a case of using the resonant bus converter, a problem of the PWM controller 500 or the PFM controller 550 is as follows.
① First, in a case of using the resonant bus converter, a relatively large inrush current in the start-up interval may be a problem. For example, in a case of using the resonant bus converter, in the start-up interval, an input voltage may be entirely applied to a series inductor for a resonance. Since the resonant bus converter has relatively low inductance of the series inductor, an inrush current may increase relatively greatly in the start-up interval. The inrush current passing through the series inductor may be referred to by the following equation.
[Equation1] ${i}_{Lr , start} = \frac{{V}_{in} - {V}_{Cr} - {V}_{O}}{{L}_{r}} {DT}_{S} \approx \frac{0.5 \times {V}_{in}}{{L}_{r}} {T}_{S}$

The i_{Lr,start} may indicate an inrush current passing through the series inductor (e.g., L_{R} of FIG. 4B) in the resonant bus converter, the Vᵢₙ may indicate an input voltage of the resonant bus converter, the V_{Cr} may indicate a series capacitor (e.g., C_{R} of FIG. 4B) resonating with the series inductor in the resonant bus converter, the Vₒ may indicate an output voltage (e.g., the voltage applied to C_{Bus} of FIG. 4B) of the resonant bus converter, the D may indicate a duty of a signal (e.g., a PWM signal) for controlling transistors of the resonant bus converter, and the Tₛ may indicate a period that is a reciprocal of a switching frequency of the signal.

Referring to the equation described above, since the Lᵣ is inductance of the series inductor and the Vᵢₙ is an input voltage obtained from outside the resonant bus converter, they may have fixed values at a time of design. Accordingly, as magnitude of the switching frequency of the signal for controlling the transistors increases (or as the period becomes shorter), the inrush current may be decreased. Accordingly, a controller for controlling the resonant bus converter needs to perform an operation of being driven at a relatively high frequency at first in the start-up interval, and changing to a relatively low frequency as proceeding to the steady state interval.

For example, a stress of an electronic device 300 may include a stress of transistors operating as switches in the DC-DC converter. For example, each of the transistors may include a resistor and a capacitor connected in parallel therein. In a case that an excessive current passes through the resistor, the transistors may be damaged by a stress according to the excessive current. For example, magnitude of the current may be related to magnitude of the inrush current. In the start-up interval, by reducing the magnitude of the inrush current, the stress of the transistors may be reduced.

For example, it is assumed that the resonant bus converter transfers power of at least 1kW. Considering a stress of elements in the resonant bus converter, a switching frequency between a minimum of 500kHz and a maximum of 1MHz is required in the start-up interval. In a case of using the PWM controller 500, since the switching frequency is fixed, when the switching frequency is increased in the start-up interval, the switching frequency after the start-up interval may be changed to have a frequency appropriate for the steady state interval. In addition, in a case of using the PFM controller 550, the switching frequency should be variable to have a frequency of approximately 500kHz or more in the start-up interval, but a variable range of the PFM controller 550 may be limited.
② Second, in a case of using the resonant bus converter, the controller (e.g., the PWM controller 500 or the PFM controller 550) may have a high OCP level. Since the controller has OCP of one fixed level, considering characteristics of a system having a wide input voltage range (e.g., -36V to -60V), an OCP level based on a low input voltage needs to be set. For example, in a case that power used by the resonant bus converter is 1000W, magnitude of a current passing through input power at a low input voltage (e.g., -36V) may be approximately 27A, and magnitude of the current at a high input voltage (e.g., -60V) may be approximately 16A. Since the OCP level is detected (or sensed) using the magnitude of the current passing through the input power, the OCP level may be set to a value based on 27A. Accordingly, in a case that the same OCP level as that at the relatively low input voltage is used at the relatively high input voltage, OCP according to the current may operate at a point (e.g., 60*27 = approximately 1620W) having relatively high power. Accordingly, in a case that OCP operates while using the relatively high input voltage (or in a case that an abnormal operation is performed), stress of elements in the resonant bus converter may increase, and a probability of damage may increase. Accordingly, the OCP level of the controller needs to be adjusted in consideration of the input voltage of the resonant bus converter.
③ A third problem may be related to that the controller (e.g., the PWM controller 500 or the PFM controller 550) turns OFF an operation when OCP operates and performs a hiccup function (or mode) for auto recovery. For example, the hiccup function may include periodically attempting restart (or ON). In a case of using the resonant bus converter, even in a case of attempting the restart, a relatively high-frequency switching frequency may be required in consideration of an inrush current. In this case, a circuit for resetting (or, refreshing)) such that the switching frequency may be changed to the high frequency may be required. Referring to the Equation 1, in a case that magnitude of an input voltage used at an initial start is relatively small, the inrush current may be lowered. However, in a case that the restart by the auto recovery is performed after a fault (or a fault state) of the controller occurs, magnitude of the input voltage may have a relatively high value, and thus the inrush current may increase. For example, the fault may include a case in which a current exceeding an OCP level is sensed or a short of a portion of elements is detected. Accordingly, even in a case of the restart, in order to lower the inrush current, a switching frequency of a signal generated and output from the controller needs to be set to a high frequency.
④ A fourth problem may be related to the second problem. For example, when the controller (e.g., the PWM controller 500 or the PFM controller 550) is in fault (or in the fault state), a circuit for reducing a stress of elements (e.g., the transistor) in the resonant bus converter while performing the hiccup function is required. For example, in a case that the controller is restarted (or a start of the start-up interval occurs) as the hiccup function is performed, the controller may perform the hiccup function until the fault is resolved. However, as a signal for driving the elements is provided according to the hiccup function, the elements may be temporarily operated. Accordingly, a current passes through the elements, and thus additional stress may be applied. Accordingly, in order to prevent secondary burnt of the resonant bus converter, a circuit for limiting an inrush current in a restart operation according to the auto recovery after the fault may be required.
⑤ Finally, in a case that there is no power required by the system including the resonant bus converter or in an Idle mode, an output voltage of the resonant bus converter may increase without being regulated. The resonant bus converter may generate an input voltage as an output voltage at a fixed frequency in the steady state without receiving a separate feedback signal, and transfer the output voltage to an application portion (e.g., the RF component 330 of FIG. 3) in the system. In this case, due to parasitic components (e.g., parasitic capacitance) seen at a rectifying end for the output, the output voltage may increase without being regulated. For the regulation of the output voltage, a method of adding a dummy load or performing the hiccup function at a low load is used, but there is a disadvantage of low efficiency and a slow response speed. Considering characteristics of an electronic device (e.g., communication equipment) requiring an Idle mode operation for a relatively long time and a fast response speed, a solution capable of high-efficiency no-load regulation without increasing the output voltage may be required.

Hereinafter, the present disclosure proposes a PWM circuit for controlling an isolated bus converter (e.g., a resonant bus converter) for communication equipment (e.g., an RU or an MMU). The isolated bus converter has a circuit-wise useful and simple topology, but the above-described problems exist. The present disclosure may provide solutions for solving the above-described problems by using simple processing at a signal level of a circuit (e.g., an analog IC) having a low production cost and a small size. Although implementation may be performed with a digital IC, the digital IC has relatively a high production cost, and a circuit configuration for driving the digital IC may be complicated. In addition, since the digital IC additionally requires separate fusing (e.g., flash fusing) or a firmware download operation, the production cost may further increase.

A control circuit according to the present disclosure and an electronic device including the same may use a PWM controller (e.g., the PWM controller 500) and an additional circuit connected to the PWM controller or an additional circuit in a DC-DC converter connected to the PWM controller. The control circuit according to the present disclosure and the electronic device including the same may use the PWM controller (e.g., the PWM controller 500) in which PFM control is implemented to perform modulation of a switching frequency in the start-up interval by adding the additional circuit. In addition, the control circuit according to the present disclosure and the electronic device including the same may reduce a stress of elements in the DC-DC converter in which the PWM controller is used by adding the additional circuit. Accordingly, the control circuit according to the present disclosure and the electronic device including the same may reduce a production cost and reduce a size of the electronic device by using the additional circuit having a relatively simple configuration.

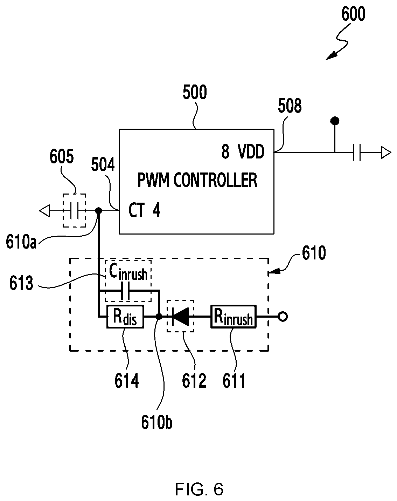

FIG. 6 illustrates an example of a control circuit including a switching circuit for adjusting a switching frequency of an output signal of a PWM controller.

A control circuit 600 of FIG. 6 may be an example of the control circuit 320 of FIG. 3. For example, the control circuit 600 may be connected to the power circuit 310 of FIG. 3. For example, the power circuit 310 may include a DC-DC converter that is a resonant bus converter. For example, the control circuit 600 may be connected to a gate of a transistor of the DC-DC converter. For example, the control circuit 600 may generate a signal and control driving of the transistor (or the gate) through the generated signal. For example, the signal may be referred to as a PWM signal.

Referring to FIG. 6, the control circuit 600 may include a PWM controller 500, a lumped element 605, and a switching circuit 610. For example, the control circuit 600 may include the PWM controller 500 of FIG. 5A. For example, the PWM controller 500 of the control circuit 600 may include at least a portion of a plurality of pins included in the controller 500 of FIG. 5A. In FIG. 6, for convenience of description, the PWM controller 500 is illustrated as including a pin 504 and a pin 508, but an embodiment of the present disclosure is not limited thereto. For example, the pin 504 may be an adjusting pin for adjusting a switching frequency of a signal (or a PWM signal) output from the PWM controller 500.

According to an embodiment, the lumped element 605 may be connected to the pin 504. For example, the lumped element 605 may be connected to the pin 504 through a node 610a. For example, the lumped element 605 may include at least one of a resistor or a capacitor. For example, in a steady state interval, the switching frequency of the PWM signal may be adjusted (or determined) according to an element value of the lumped element 605 connected to the pin 504. For example, in a case that the lumped element 605 is a resistor, the element value may be resistance. For example, in a case that the lumped element 605 is a capacitor, the element value may be capacitance. According to an embodiment, the switching circuit 610 may be connected to the pin 504. For example, the switching circuit 610 may be connected to the pin 504 through the node 610a.

According to an embodiment, the switching circuit 610 may include a first resistor 611 Rᵢₙᵣᵤₛₕ, a diode 612, a capacitor 613 Cᵢₙᵣᵤₛₕ, and a second resistor 614 R_{dis}. For example, a driving voltage V_{DD} of the PWM controller 500 may be applied to the first resistor 611 Rᵢₙᵣᵤₛₕ. According to an embodiment, the diode 612 may be connected to each of the first resistor 611 Rᵢₙᵣᵤₛₕ, the capacitor 613 Cᵢₙᵣᵤₛₕ, and the second resistor 614 R_{dis}. For example, the first resistor 611 Rᵢₙᵣᵤₛₕ may be connected to an anode of the diode 612. For example, each of the capacitor 613 Cᵢₙᵣᵤₛₕ and the second resistor 614 R_{dis} may be connected to a cathode of the diode 612 through a node 610b. The capacitor 613 Cᵢₙᵣᵤₛₕ and the second resistor 614 R_{dis} may be disposed in parallel. For example, the capacitor 613 Cᵢₙᵣᵤₛₕ and the second resistor 614 R_{dis} may be connected in parallel between a node 610a at which the switching circuit 610 is connected to the pin 504 and the lumped element 605, and the node 610b connected to the diode 612.

According to an embodiment, the switching circuit 610 may be used to adjust a driving frequency of the PWM signal in the start-up interval of the PWM controller 500. Referring to the above, in the steady state interval, the driving frequency of the PWM signal may be determined based on an element value of the lumped element 605. For example, in a case that the lumped element 605 is a capacitor C_{CT}, the lumped element 605 may be charged by a current source located inside the pin 504. As the lumped element 605 is discharged in a case that a voltage applied to the lumped element 605 reaches a reference voltage, a triangular wave for generating the PWM signal may be generated. In this case, a time to reach the reference voltage may be used to determine the switching frequency of the PWM signal. Accordingly, the switching circuit 610 may adjust the switching frequency of the PWM signal by adjusting the time required until the voltage of the lumped element 605 reaches the reference voltage.

For example, in the start-up interval, as the driving voltage V_{DD} is applied to the first resistor 611 Rᵢₙᵣᵤₛₕ, a current passing through the first resistor 611 Rᵢₙᵣᵤₛₕ may be additionally added to the lumped element 605. Accordingly, the voltage of the lumped element 605 may reach the reference voltage more quickly. In the start-up interval, as time elapses after the driving voltage V_{DD} is applied to the first resistor 611 Rᵢₙᵣᵤₛₕ and before the steady state interval, a voltage applied to the capacitor 613 Cᵢₙᵣᵤₛₕ may gradually increase. As the voltage applied to the capacitor 613 Cᵢₙᵣᵤₛₕ gradually increases, a voltage applied to the first resistor 611 Rᵢₙᵣᵤₛₕ may gradually decrease. Magnitude of the current passing through the first resistor 611 Rᵢₙᵣᵤₛₕ may also decrease. For example, a length of the start-up interval may be determined according to a time constant based on the first resistor 611 Rᵢₙᵣᵤₛₕ and the capacitor 613 Cᵢₙᵣᵤₛₕ. For example, in a case that the voltage applied to the capacitor 613 Cᵢₙᵣᵤₛₕ corresponds to the driving voltage V_{DD}, magnitude of the current passing through the first resistor 611 Rᵢₙᵣᵤₛₕ may become 0. As the current added to the lumped element 605 decreases, the switching frequency of the PWM signal may be determined by the lumped element 605. In other words, in the steady state interval, the switching frequency of the PWM signal may be adjusted based on the lumped element 605. The second resistor 614 R_{dis} may be used to discharge a residual voltage charged in the capacitor 613 Cᵢₙᵣᵤₛₕ.

Referring to the above, by connecting the switching circuit 610 to the pin 504 of the PWM controller 500, control in a PFM method (change of a switching frequency) may be implemented in the start-up interval. Accordingly, even when using the PWM controller 500, a control circuit according to the present disclosure and an electronic device 300 including the same may provide a relatively high switching frequency in the start-up interval and provide a relatively low switching frequency as entering the steady state interval. As the relatively high switching frequency is provided in the start-up interval, an inrush current in the start-up interval is lowered, and thus a stress of an element (e.g., transistors) of the DC-DC converter connected to the PWM controller 500 may be reduced.

In FIG. 6, the switching circuit 610 is illustrated as including the capacitor 613 Cᵢₙᵣᵤₛₕ and the second resistor 614 R_{dis} disposed in parallel, but the present disclosure is not limited thereto. For example, the switching circuit 610 may also be implemented through an inductor and a resistor disposed in series.

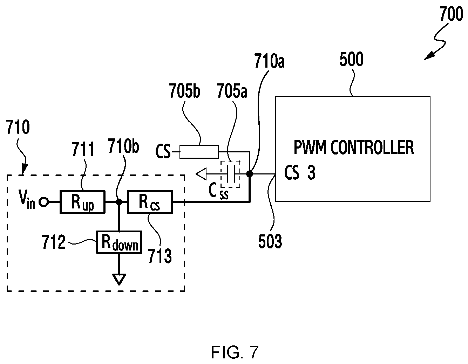

FIG. 7 illustrates an example of a control circuit including a voltage dividing circuit for adjusting an over current protection (OCP) level of a PWM controller.

A control circuit 700 of FIG. 7 may be an example of the control circuit 320 of FIG. 3. For example, the control circuit 700 may be connected to the power circuit 310 of FIG. 3. For example, the power circuit 310 may include a DC-DC converter that is a resonant bus converter. For example, the control circuit 700 may be connected to a gate of a transistor of the DC-DC converter. For example, the control circuit 700 may generate a signal and control driving of the transistor (or the gate) through the generated signal. For example, the signal may be referred to as a PWM signal.

Referring to FIG. 7, the control circuit 700 may include a PWM controller 500 and a voltage dividing circuit 710. For example, the control circuit 700 may include the PWM controller 500 of FIG. 5A. For example, the PWM controller 500 of the control circuit 700 may include at least a portion of a plurality of pins included in the controller 500 of FIG. 5A. In FIG. 7, for convenience of description, the PWM controller 500 is illustrated as including a pin 503, but an embodiment of the present disclosure is not limited thereto. For example, the pin 503 may indicate a current sensing pin for sensing a current for over current protection (OCP).

According to an embodiment, the voltage dividing circuit 710 may include a first dividing resistor 711 Rᵤₚ to which an input voltage Vᵢₙ of the DC-DC converter is applied, a second dividing resistor 712 R_{down}, connected to a ground, and a third dividing resistor 713 R_{CS} connected to the pin 503. For example, the third dividing resistor 713 R_{CS} may be connected to the pin 503, a capacitor 705a C_{CS} connected to the pin 503, and an element 705a (e.g., a resistor) connected to the pin 503 through a node 710a. For example, the first dividing resistor 711 Rᵤₚ, the second dividing resistor 712 R_{down}, and the third dividing resistor 713 R_{CS} may be connected to each other through a node 710b.

According to an embodiment, in a case that a level of a voltage applied to the pin 503 exceeds a reference value, the PWM controller 500 may perform an OCP operation. For example, in a case that a current passing through the pin 503 (or a current sensed by the pin 503) increases, the level of the voltage may exceed the reference value. For example, the OCP operation may include OFF of an operation of the PWM controller 500.

According to an embodiment, since the reference value has a fixed value, the reference value may be relatively adjusted according to the input voltage Vᵢₙ by changing the level of the voltage applied to the pin 503 dependently on the input voltage Vᵢₙ. For example, voltage information of the input voltage Vᵢₙ may be applied to the pin 503 through the voltage dividing circuit 710. For example, the voltage information may be a voltage divided by the voltage dividing circuit 710 from the input voltage Vᵢₙ. The voltage information applied to the pin 503 may increase as the input voltage Vᵢₙ increases. In other words, the voltage information may be proportional to the input voltage Vᵢₙ. In a case that the input voltage Vᵢₙ is relatively high (e.g., -60V), the voltage information applied to the pin 503 increases, and the OCP operation of the PWM controller 500 may be performed by a current passing through the pin 503 having a relatively low value. Alternatively, in a case that the input voltage Vᵢₙ is relatively low (e.g., -36V), the voltage information applied to the pin 503 decreases, and the OCP operation of the PWM controller 500 may be performed by a current passing through the pin 503 having a relatively high value.

Referring to the above, the control circuit 700 may set the voltage applied to the pin 503 for current sensing of the PWM controller 500 to have a value dependent on an input voltage Vᵢₙ through the voltage dividing circuit 710. For example, the voltage applied to the pin 503 may be referred to as a threshold voltage for the OCP. For example, the threshold voltage may be adjusted according to the input voltage Vᵢₙ by the voltage dividing circuit 710. As the voltage applied to the pin 503 varies according to the input voltage Vᵢₙ , the OCP operation may be performed at a low current level at a high input voltage, and the OCP operation may be performed at a high current level at a low input voltage.

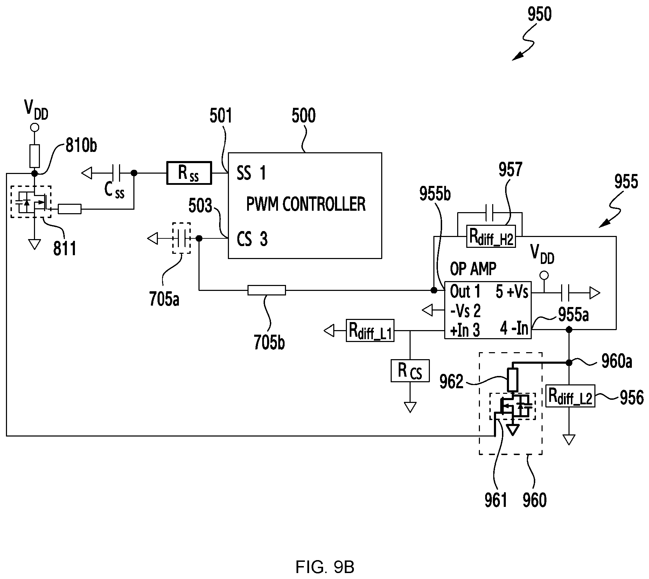

Referring to FIG. 7, a bias voltage may be formed at the pin 503 by the voltage dividing circuit 710. As adjustment of a gain of a current amplification circuit connected to an element 705b (hereinafter, a power amplifier 955 of FIG. 9B) is performed, a level of the bias voltage may be adjusted (or removed). In addition, according to a super position based on the third dividing resistor 713 R_{CS}, the level of the bias voltage may be adjusted.

In FIG. 7, the control circuit 710 is illustrated as including the voltage dividing circuit 710 including three resistors, but the present disclosure is not limited thereto. For example, the control circuit 710 may also include the voltage dividing circuit 710 including three capacitors. For example, the voltage dividing circuit 710 of FIG. 7 may include a configuration for dividing the input voltage Vᵢₙ and providing the voltage information of the input voltage Vᵢₙ to the pin 503.

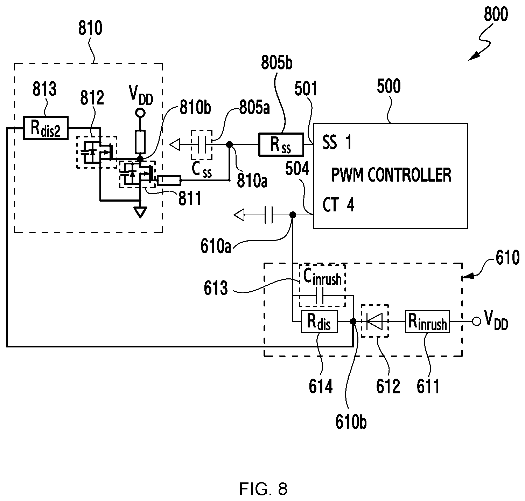

FIG. 8 illustrates an example of a control circuit including a discharging circuit of a capacitor for adjusting a switching frequency.

A control circuit 800 of FIG. 8 may be an example of the control circuit 320 of FIG. 3. For example, the control circuit 800 may be connected to the power circuit 310 of FIG. 3. For example, the power circuit 310 may include a DC-DC converter that is a resonant bus converter. For example, the control circuit 800 may be connected to a gate of a transistor of the DC-DC converter. For example, the control circuit 800 may generate a signal and control driving of the transistor (or the gate) through the generated signal. For example, the signal may be referred to as a PWM signal.

Referring to FIG. 8, the control circuit 800 may include a PWM controller 500, a switching circuit 610, and a discharging circuit 810. For example, the control circuit 800 may include the PWM controller 500 of FIG. 5A. For example, the PWM controller 500 of the control circuit 800 may include at least a portion of a plurality of pins included in the controller 500 of FIG. 5A. In FIG. 8, for convenience of description, the PWM controller 500 is illustrated as including a pin 504 and a pin 501, but an embodiment of the present disclosure is not limited thereto. For example, the pin 504 may be an adjusting pin for adjusting a switching frequency of a signal (or a PWM signal) output from the PWM controller 500. For example, the pin 501 may indicate a pin for gradually increasing a duty of PWM signals output from the PWM controller 500. For example, the switching circuit 610 of the control circuit 800 may be an example of the switching circuit 610 of FIG. 6. Referring to FIG. 8, the PWM controller 500 of the control circuit 800 may be connected to the switching circuit 610 through the pin 504.

According to an embodiment, the discharging circuit 810 of the control circuit 800 may include a first transistor 811, a second transistor 812, and a discharging resistor 813 R_{dis2}.

For example, the first transistor 811 may include a gate connected to the pin 501 through a node 810a, a drain to which a driving voltage V_{DD} of the PWM controller 500 is applied, and a source connected to a ground. For example, the gate of the first transistor 811 may be connected to the node 810a through an element (e.g., a resistor) for inducing a current. The element may also be omitted. The node 810a may indicate a node to which the gate of the first transistor 811, a duty capacitor 805a C_{SS}, and a duty resistor 805b R_{SS} are connected. For example, the drain of the first transistor 811 may be connected to a gate of the second transistor 812 through a node 810b. For example, the source of the first transistor 811 may be connected to a source of the second transistor 812.

For example, the second transistor 812 may include a gate to which a driving voltage V_{DD} is applied, a drain connected to the discharging resistor 813 R_{dis2}, and a source connected to a ground. For example, the gate of the second transistor 812 may be connected to the drain of the first transistor 811 through a node 810b. For example, the source of the second transistor 812 may be connected to the source of the first transistor 811. For example, the drain of the second transistor 812 may be connected to the switching circuit 610 through a dividing resistor 813 R_{dis2}. For example, the dividing resistor 813 R_{dis2} may connect the drain of the second transistor 812 and the node 610b of the switching circuit 610.

The PWM controller 500 may charge the duty capacitor 805a Css through a current source inside the pin 501 to provide a soft start function in a start-up interval. In a case that the duty capacitor 805a C_{SS} reaches a reference voltage, the PWM controller 500 may stop the soft start function. Thereafter, in a case of a fault of the PWM controller 500, as the PWM controller 500 stops output (e.g., stopping or OFF of output of the PWM signal), the duty capacitor 805a Css may be discharged to another reference voltage. For example, the another reference voltage may be a voltage lower than the reference voltage. After the duty capacitor 805a Css is discharged to the another reference voltage, charging of the duty capacitor 805a Css to the reference voltage and discharging of the duty capacitor 805a Css to the another reference voltage may be repeated according to an auto recovery operation.

According to an embodiment, according to the switching circuit 610, a switching frequency of the PWM signal may be changed in the start-up interval of the PWM controller 500. For example, as the capacitor 613 Cᵢₙᵣᵤₛₕ in the switching circuit 610 is charged by the driving voltage V_{DD} in the start-up interval, the switching frequency may decrease. After the start-up interval, as the fault of the PWM controller 500 is detected, restart may be performed. Since the capacitor 613 Cᵢₙᵣᵤₛₕ is already charged to correspond to the driving voltage V_{DD} during the start-up interval, the switching frequency having a high frequency may be used at the restart. Accordingly, in a case of the fault, discharging of the capacitor 613 Cᵢₙᵣᵤₛₕ of the switching circuit 610 may be required.

According to an embodiment, the discharging circuit 810 may be used for discharging the capacitor 613 Cᵢₙᵣᵤₛₕ in a case of the fault of the PWM controller 500. For example, the gate of the first transistor 811 of the discharging circuit 810 may be ON before the fault. A state of the gate of the first transistor 811 of the discharging circuit 810 may be changed from ON to OFF by a voltage of the pin 501 decreased according to the fault. As the first transistor 811 is turned OFF, a state of the second transistor 812 (or the gate of the second transistor 812) may be changed from OFF to ON. The second transistor 812 may be changed to ON as the fault is detected, and may be electrically connected to the switching circuit 610. In other words, as the second transistor 812 is turned ON, the capacitor 613 Cᵢₙᵣᵤₛₕ of the switching circuit 610 and the discharging resistor 813 R_{dis2} are connected, and energy charged in the capacitor 613 Cᵢₙᵣᵤₛₕ may be consumed through the discharging resistor 813 R_{dis2}. Thereafter, in a case that the start-up interval starts again, the second transistor 812 is changed from ON to OFF, and the switching circuit 610 including the discharged capacitor 613 Cᵢₙᵣᵤₛₕ may perform switching such that the switching frequency of the PWM signal has a high frequency. For switching to have the high frequency in the restarted start-up interval, the above-described operations of FIG. 6 may be referred to.

In FIG. 8, the control circuit 800 is illustrated as including the discharging circuit 810 including two transistors which are an npn type (e.g., the first transistor 811 and the second transistor 812), but the present disclosure is not limited thereto. For example, the control circuit 800 may also include the discharging circuit 810 including one transistor which is a pnp type. For example, the transistor which is the pnp type may perform a function (or an operation) of the first transistor 811 and the second transistor 812 substantially identically.

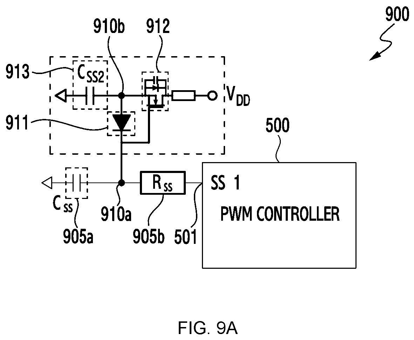

FIG. 9A and FIG. 9B illustrate examples of a control circuit including a protection circuit.

A control circuit 900 of FIG. 9A may be an example of the control circuit 320 of FIG. 3. For example, the control circuit 900 may be connected to the power circuit 310 of FIG. 3. For example, the power circuit 310 may include a DC-DC converter that is a resonant bus converter. For example, the control circuit 900 may be connected to a gate of a transistor of the DC-DC converter. For example, the control circuit 900 may generate a signal and control driving of the transistor (or the gate) through the generated signal. For example, the signal may be referred to as a PWM signal.

Referring to FIG. 9A, the control circuit 900 may include a PWM controller 500 and a first protection circuit 910. For example, the control circuit 900 may include the PWM controller 500 of FIG. 5A. For example, the PWM controller 500 of the control circuit 900 may include at least a portion of a plurality of pins included in the controller 500 of FIG. 5A. In FIG. 9A, for convenience of description, the PWM controller 500 is illustrated as including a pin 501, but an embodiment of the present disclosure is not limited thereto. For example, a pin 504 may be an adjusting pin for adjusting a switching frequency of a signal (or a PWM signal) output from the PWM controller 500. For example, the pin 501 may indicate a pin for gradually increasing a duty of PWM signals output from the PWM controller 500.

According to an embodiment, the first protection circuit 910 of the control circuit 900 may include a diode 911, a transistor 912, and a protection capacitor 913 C_{SS2}.

For example, the diode 911 of the first protection circuit 910 may include a cathode connected to a gate of the transistor 912 and a node 910a, and an anode connected to the protection capacitor 913 C_{SS2}, and a source of the transistor 912. For example, the node 910a may indicate a node to which the diode 911, the gate of the transistor 912, a duty capacitor 905a C_{SS}, and a duty resistor 905b R_{SS} are connected. The duty capacitor 905a C_{SS} and the duty resistor 905b R_{SS} may be understood as being substantially identical to the duty capacitor 805a C_{SS} and the duty resistor 805b R_{SS} of FIG. 8.

For example, the transistor 912 of the first protection circuit 910 may include the gate connected to the cathode of the diode 911, a drain to which a driving voltage V_{DD} of the PWM controller 500 is applied, and a source connected to the anode of the diode 911 and the protection capacitor 913 C_{SS2}. In FIG. 9A, an example in which the driving voltage V_{DD} is applied to the drain of the transistor 912 is illustrated, but the present disclosure is not limited thereto. For example, a voltage source having a designated value (e.g., 3.3V) other than the driving voltage V_{DD} may also be applied to the drain of the transistor 912.

According to an embodiment, the protection capacitor 913 C_{SS2} of the first protection circuit 910 may be charged while a voltage applied to the pin 501 increases according to a soft start function in a start-up interval of the PWM controller 500. For example, while the voltage applied to the pin 501 increases, a voltage is applied to the gate of the transistor 912, and thus the protection capacitor 913 C_{SS2} may be charged by the driving voltage V_{DD}. According to an embodiment, while the PWM controller 500 is in a steady state interval, the voltage applied to the pin 501 is fixed to the reference voltage, and the protection capacitor 913 C_{SS2} may stop charging. For example, the protection capacitor 913 C_{SS2} stopping the charging may be in a fully charged state. According to an embodiment, in a case of a fault of the PWM controller 500, in a case that the voltage applied to the pin 501 decreases, charged energy may be transferred from the protection capacitor 913 C_{SS2} to the pin 501 through the diode 911. For example, in a case that the voltage applied to the pin 501 decreases, the diode 911 may be conducted. As the energy of the protection capacitor 913 C_{SS2} is transferred to the pin 501 through the conducted diode 911, a decreasing speed of the voltage applied to the pin 501 may be lowered. For example, it is assumed that, in a case of not using the first protection circuit 910, the voltage applied to the pin 501 decreases at a first speed. In a case that the energy is transferred from the protection capacitor 913 C_{SS2} by using the first protection circuit 910, the voltage applied to the pin 501 may decrease at a second speed slower than the first speed. In order for the PWM controller 500 to perform start-up again, the voltage applied to the pin 501 needs to be changed to be less than or equal to the another reference voltage. Accordingly, by slowing the decreasing speed of the voltage applied to the pin 501 through the protection capacitor 913 C_{SS2} of the first protection circuit 910, a period of auto recovery may be slowed.

According to the above, in a case that an element of the power circuit 310 including the DC-DC converter is damaged, an overcurrent may occur in the power circuit 310. In order to protect this, a protection circuit providing an OCP operation (function) may be used. The damage of the element may occur when a stress is accumulated in elements of the power circuit 310. Accordingly, in order to reduce the stress, an occurrence frequency of the stress may be reduced (or a period of auto recovery may be increased), or a level of the stress may be reduced. For example, the first protection circuit 900 of FIG. 9A may reduce the stress by increasing the period of the auto recovery.

A control circuit 950 of FIG. 9B may be an example of the control circuit 320 of FIG. 3. For example, the control circuit 950 may be connected to the power circuit 310 of FIG. 3. For example, the power circuit 310 may include a DC-DC converter that is a resonant bus converter. For example, the control circuit 950 may be connected to a gate of a transistor of the DC-DC converter. For example, the control circuit 950 may generate a signal and control driving of the transistor (or the gate) through the generated signal. For example, the signal may be referred to as a PWM signal.

Referring to FIG. 9B, the control circuit 950 may include a PWM controller 500, an operational amplifier (OP AMP) 955, and a second protection circuit 960. For example, the control circuit 950 may include the PWM controller 500 of FIG. 5A. For example, the PWM controller 500 of the control circuit 950 may include at least a portion of a plurality of pins included in the controller 500 of FIG. 5A. In FIG. 9B, for convenience of description, the PWM controller 500 is illustrated as including a pin 501 and a pin 503, but an embodiment of the present disclosure is not limited thereto. For example, the pin 501 may indicate a pin for gradually increasing a duty of PWM signals output from the PWM controller 500. For example, the pin 503 may indicate a current sensing pin for sensing a current for over current protection (OCP). For example, the operational amplifier 955 may include a differential amplifier.

According to an embodiment, the operational amplifier 955 may include a plurality of pins. For example, the operational amplifier 955 may include a plurality of input ends +in and - in, a plurality of voltage ends +Vₛ and - Vₛ, and an output end (Out) 955b. For example, the plurality of input ends may include an input end 955a that is a - input end. For example, an output resistor 957 R_{diff_H2} may be disposed between the input end 955a and the output end 955b of the operational amplifier 955. An input resistor 956 R_{diff_L2} may be disposed between the input end 955a and a ground.

According to an embodiment, the operational amplifier 955 may be connected to the pin 503. For example, the output end 955b of the operational amplifier 955 may be connected to the pin 503 through an element 705b.

According to an embodiment, the second protection circuit 960 may include a transistor 961 and a protection resistor 962. For example, the transistor 961 of the second protection circuit 960 may include a source connected to the ground, a gate connected to a drain of a first transistor 811 of a discharging circuit 810, and a drain connected to the protection resistor 962.

According to an embodiment, the second protection circuit 960 may be disposed between the operational amplifier 955 and the discharging circuit 810. For example, a gate of the transistor 961 of the second protection circuit 960 may be connected to a drain of the first transistor 811 of the discharging circuit 810 through a node 810b, and a driving voltage V_{DD} of the PWM controller 500 may be applied to the gate of the transistor 961. For example, the protection resistor 962 may be connected to the input end 955a through a node 960a.

According to an embodiment, the PWM controller 500 may obtain current information of input power of the DC-DC converter through the pin 503. For example, the operational amplifier 955 may generate the current information amplified by a gain from a value related to a current passing through the input power. For example, the gain may be determined by the input resistor 956 R_{diff_L2} and the output resistor 957 R_{diff_H2}. For example, the gain may be calculated as R_{diff_H2}/R_{diff_L2}. The PWM controller 500 may determine whether to perform an OCP operation by using the current information amplified according to the gain sensed by the pin 503.

According to an embodiment, in a start-up interval of the PWM controller 500, the gain may be changed. For example, in the start-up interval, as a voltage applied to the pin 501 increases, a state of the gate of the transistor 961 of the second protection circuit 960 may be changed from OFF to ON. For example, the transistor 961 of the second protection circuit 960 may operate as ON in the start-up interval as a state of the first transistor 811 is changed. While the transistor 961 is driven as ON, a resistance seen at the input end 955a of the operational amplifier 955 may be defined as a parallel resistance between the input resistor 956 and the protection resistor 962. Accordingly, the gain may be changed in the start-up interval. For example, the gain may be increased in the start-up interval as a denominator value of an equation for calculating the gain is decreased by the parallel resistance. Accordingly, in the start-up interval, the PWM controller 500 may recognize a relatively low input current as a higher value (or current) according to the gain. Accordingly, even in a case that the relatively low input current is used in the start-up interval, the PWM controller 500 may perform the OCP operation (or function).

According to the above, in a case that an element of the power circuit 310 including the DC-DC converter is damaged, an overcurrent may occur in the power circuit 310. In order to protect this, a protection circuit providing the OCP operation (function) may be used. The damage of the element may occur when a stress is accumulated in elements of the power circuit 310. Accordingly, in order to reduce the stress, an occurrence frequency of the stress (e.g., a period of auto recovery) may be reduced, or a level of the stress may be reduced. For example, the second protection circuit 950 of FIG. 9B may reduce the stress by relatively adjusting an OCP level.

In FIG. 9B, the control circuit 950 in which the operational amplifier 955 is disposed outside the PWM controller 500 is illustrated, but the present disclosure is not limited thereto. For example, the PWM controller 500 may include the operational amplifier 955. In this case, as the second protection circuit 960 is connected to the operational amplifier 955, the second protection circuit 960 may also be included inside the PWM controller 500.

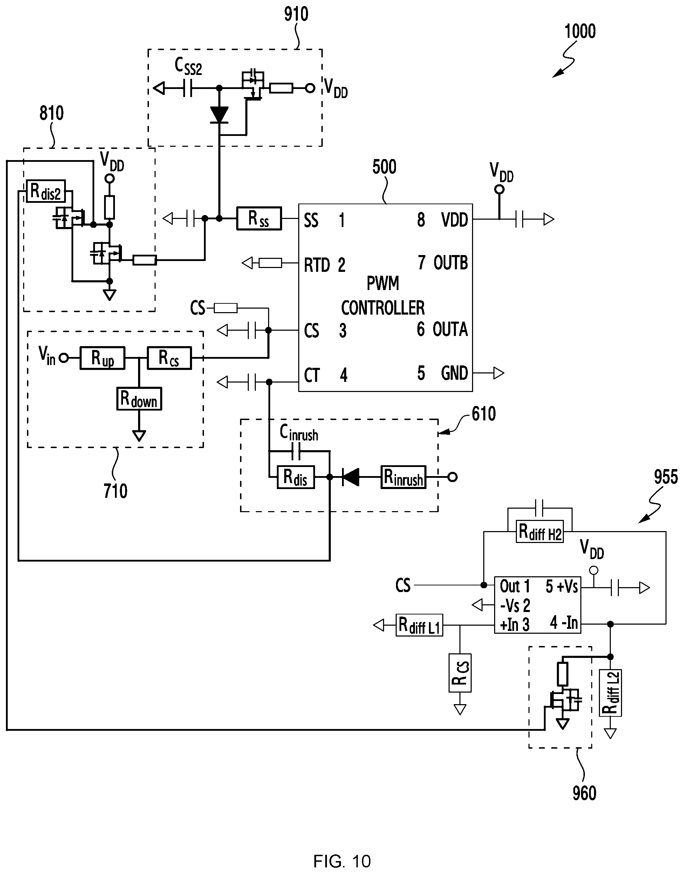

FIG. 10 illustrates an example of a control circuit connected to a DC-DC converter.

A control circuit 1000 of FIG. 10 may be an example of the control circuit 320 of FIG. 3. For example, the control circuit 1000 may be connected to the power circuit 310 of FIG. 3. For example, the power circuit 310 may include a DC-DC converter that is a resonant bus converter. For example, the control circuit 1000 may be connected to a gate of a transistor of the DC-DC converter. For example, the control circuit 1000 may generate a signal and control driving of the transistor (or the gate) through the generated signal. For example, the signal may be referred to as a PWM signal.

According to an embodiment, the control circuit 1000 may include a PWM controller 500, a switching circuit 610, a voltage dividing circuit 710, a discharging circuit 810, a first protection circuit 910, an operational amplifier 955, and a second protection circuit 920. For example, the control circuit 1000 may include the PWM controller 500 of FIG. 5A. For example, the PWM controller 500 of the control circuit 1000 may include at least a portion of a plurality of pins included in the controller 500 of FIG. 5A. For example, the control circuit 1000 may include the switching circuit 610 of FIG. 6. For example, the switching circuit 610 may be connected to a pin 504 of the PWM controller 500 and the discharging circuit 810. For example, the control circuit 1000 may include the voltage dividing circuit 710 of FIG. 7. For example, the voltage dividing circuit 710 may be connected to a pin 503 of the PWM controller 500. For example, the control circuit 1000 may include the discharging circuit 810 of FIG. 8. For example, the discharging circuit 810 may be connected to a pin 501 of the PWM controller 500 and the switching circuit 610. For example, the control circuit 1000 may include the first protection circuit 910. For example, the first protection circuit 910 may be connected to the pin 501 of the PWM controller 500. For example, the control circuit 1000 may include the second protection circuit 960. For example, the second protection circuit 960 may be connected to the operational amplifier 955 and the discharging circuit 810.

In FIG. 10, the control circuit 1000 is illustrated as including the switching circuit 610, the voltage dividing circuit 710, the discharging circuit 810, the first protection circuit 910, and the second protection circuit 960, but the present disclosure is not limited thereto. For example, the control circuit 1000 may include the switching circuit 610. For example, the control circuit 1000 may include the switching circuit 610 and the discharging circuit 810. For example, the control circuit 1000 may include the first protection circuit 910. For example, the control circuit 1000 may include the switching circuit 610, the discharging circuit 810, and the second protection circuit 960. The above-described examples are merely exemplary examples for convenience of description, and the present disclosure is not limited thereto. In other words, the control circuit 1000 may include the switching circuit 610, the voltage dividing circuit 710, the discharging circuit 810, the first protection circuit 910, the second protection circuit 960, or a combination of circuits.

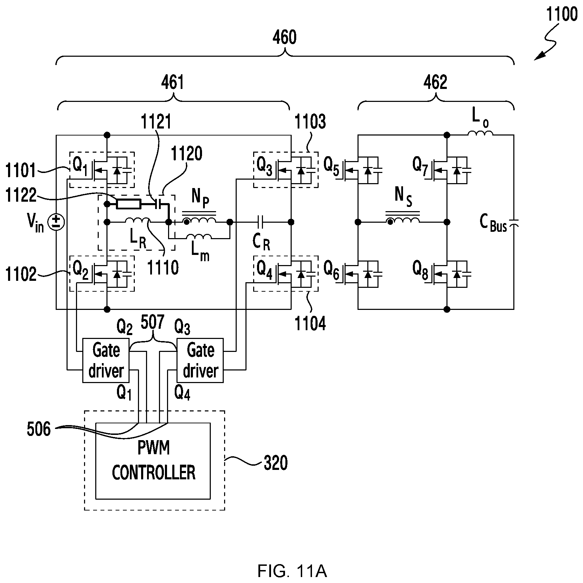

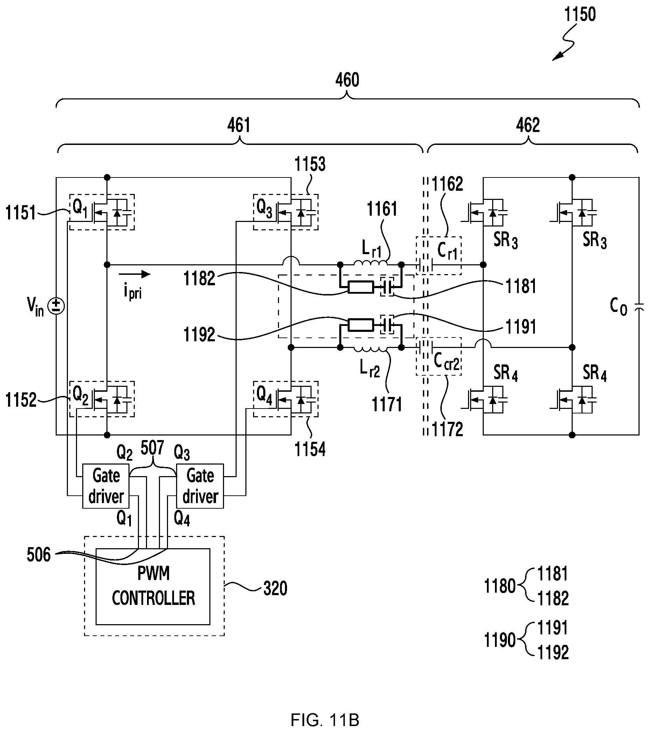

FIG. 11A and FIG. 11B illustrate examples of a DC-DC converter including a damping circuit.

A DC-DC converter 1100 of FIG. 11A may be included in the power circuit 310 of FIG. 3. For example, the DC-DC converter 1100 may be connected to a control circuit 320. For example, the control circuit 320 may include the control circuit 600 of FIG. 6, the control circuit 700 of FIG. 7, the control circuit 800 of FIG. 8, the control circuit 900 of FIG. 9A, the control circuit 950 of FIG. 9B, or the control circuit 1000 of FIG. 10. For example, the control circuit 320 may generate a signal and control driving of a transistor (or a gate) of the DC-DC converter 1100 through the generated signal. For example, the signal may be referred to as a PWM signal.

According to an embodiment, the DC-DC converter 1100 may include a 1 stage circuit 460. For example, the 1 stage circuit 460 may include a transformer for converting an input voltage of power into an output voltage applied to an output end C_{Bus}. For example, the transformer may include a first portion 461 and a second portion 462. For example, the first portion 461 may be referred to as an input portion (or an input part). For example, the second portion 462 may be referred to as an output portion (or an output part). For example, based on a winding ratio NP:NS between the first portion 461 and the second portion 462, an output voltage converted from an input voltage 455 may be determined.

According to an embodiment, the DC-DC converter 1100 may include a plurality of transistors 1101, 1102, 1103, and 1104. In the example of FIG. 11A, the DC-DC converter 1100 may include four transistors 1101, 1102, 1103, and 1104 in the first portion 461 (or the input portion).

According to an embodiment, a gate of each of the transistors 1101, 1102, 1103, and 1104 of the DC-DC converter 1100 may be connected to the control circuit 320. For example, the control circuit 320 may include a plurality of outputting pins 506 and 507. For example, the first outputting pin 506 may be connected to the first transistor 1101 Q1 and the fourth transistor 1104 Q4. The first transistor 1101 Q1 and the fourth transistor 1104 Q4 may be referred to as a first set of transistors. For example, the second outputting pin 507 may be connected to the second transistor 1102 Q2 and the third transistor 1103 Q3. The second transistor 1102 Q2 and the third transistor 1103 Q3 may be referred to as a second set of transistors.

According to an embodiment, a PWM signal output from the control circuit 320 may be input to the gate. The PWM signal may be used to control a time when the gate is driven. For example, in a case that a switching frequency of the PWM signal is changed, a length of the time may be adjusted. The time may indicate an interval in which the gate operates as ON. Referring to FIG. 11A, PWM signals output from the control circuit 320 may selectively drive one of the first set of transistors and the second set of transistors. For example, in a case that a PWM signal is output from the first outputting pin 506, the first set of transistors among the first set of transistors and the second set of transistors may be switched from OFF to ON. For example, in a case that a PWM signal is output from the second outputting pin 507, the second set of transistors among the first set of transistors and the second set of transistors may be switched from OFF to ON. For example, while outputting a PWM signal through the first outputting pin 506, the control circuit 320 may not output a PWM signal through the second outputting pin 507. For example, while not outputting a PWM signal through the first outputting pin 506, the control circuit 320 may output a PWM signal through the second outputting pin 507.

According to an embodiment, the DC-DC converter 1100 may include an inductor 1110 L_{R} and a capacitor C_{R} that perform a converting operation of a voltage through a resonance. For example, the inductor 1110 L_{R} is connected in series with the transformer, and thus may be referred to as a series inductor. For example, the capacitor C_{R} is connected in series with the transformer, and thus may be referred to as a series capacitor. The DC-DC converter 1100 including the inductor 1110 L_{R} and the capacitor C_{R} may be referred to as an LLC converter.

According to an embodiment, the DC-DC converter 1100 may include a damping circuit 1120. For example, the damping circuit 1120 may be disposed in parallel with the inductor 1110 L_{R}. For example, the damping circuit 1120 may include a damping capacitor 1121 and a damping resistor 1122. However, the present disclosure is not limited thereto. For example, the damping circuit 1120 may include the damping capacitor 1121.

According to an embodiment, the damping circuit 1120 may be used to prevent an increase in an output voltage of the DC-DC converter 1100 in a no load or light load situation. For example, as parasitic capacitors of transistors Q5, Q6, Q7, and Q8 in the second portion 462 operate as if being connected in parallel with the inductor 1110 L_{R}, the output voltage may increase without being regulated. The damping circuit 1120 disposed in parallel with the inductor 1110 L_{R} may remove an influence by the parasitic capacitors. Accordingly, the regulation of the output voltage may be performed in the no load or light load situation.

A DC-DC converter 1150 of FIG. 11B may be included in the power circuit 310 of FIG. 3. For example, the DC-DC converter 1150 may be connected to a control circuit 320. For example, the control circuit 320 may include the control circuit 600 of FIG. 6, the control circuit 700 of FIG. 7, the control circuit 800 of FIG. 8, the control circuit 900 of FIG. 9A, the control circuit 950 of FIG. 9B, or the control circuit 1000 of FIG. 10. For example, the control circuit 320 may generate a signal and control driving of a transistor (or a gate) of the DC-DC converter 1150 through the generated signal. For example, the signal may be referred to as a PWM signal.

According to an embodiment, the DC-DC converter 1150 may include a 1 stage circuit 460. For example, the 1 stage circuit 460 may include a transformer for converting an input voltage of power into an output voltage applied to an output end C_{O}. For example, the transformer may include a first portion 461 and a second portion 462. For example, the first portion 461 may be referred to as an input portion (or an input part). For example, the second portion 462 may be referred to as an output portion (or an output part). For example, the transformer may include a first capacitor 1162 Cᵣ₁ and a second capacitor 1172 Cᵣ₂. For example, the DC-DC converter 1150 may include a first inductor 1161 Lᵣ₁ disposed in series with the first capacitor 1162 Cᵣ₁. For example, the DC-DC converter 1150 may include a second inductor 1171 Lᵣ₂ disposed in series with the second capacitor 1172 Cᵣ₂. The first inductor 1161 Lᵣ₁ may be referred to as a first series inductor. The second inductor 1171 Lᵣ₂ may be referred to as a second series inductor.

According to an embodiment, the DC-DC converter 1150 may include a plurality of transistors 1151, 1152, 1153, and 1154. In the example of FIG. 11A, the DC-DC converter 1150 may include four transistors 1101, 1102, 1103, and 1104 in the first portion 461 (or the input portion).

According to an embodiment, a gate of each of the transistors 1151, 1152, 1153, and 1154 of the DC-DC converter 1150 may be connected to the control circuit 320. For example, the control circuit 320 may include a plurality of outputting pins 506 and 507. For example, the first outputting pin 506 may be connected to the first transistor 1151 Q1 and the fourth transistor 1154 Q4. The first transistor 1151 Q1 and the fourth transistor 1154 Q4 may be referred to as a first set of transistors. For example, the second outputting pin 507 may be connected to the second transistor 1152 Q2 and the third transistor 1153 Q3. The second transistor 1152 Q2 and the third transistor 1153 Q3 may be referred to as a second set of transistors.

According to an embodiment, a PWM signal output from the control circuit 320 may be input to the gate. The PWM signal may be used to control a time when the gate is driven. For example, in a case that a switching frequency of the PWM signal is changed, a length of the time may be adjusted. The time may indicate an interval in which the gate operates as ON. Referring to FIG. 11B, PWM signals output from the control circuit 320 may selectively drive one of the first set of transistors and the second set of transistors. For example, in a case that a PWM signal is output from the first outputting pin 506, the first set of transistors among the first set of transistors and the second set of transistors may be switched from OFF to ON. For example, in a case that a PWM signal is output from the second outputting pin 507, the second set of transistors among the first set of transistors and the second set of transistors may be switched from OFF to ON. For example, while outputting a PWM signal through the first outputting pin 506, the control circuit 320 may not output a PWM signal through the second outputting pin 507. For example, while not outputting a PWM signal through the first outputting pin 506, the control circuit 320 may output a PWM signal through the second outputting pin 507.

According to an embodiment, the DC-DC converter 1150 may include a plurality of damping circuits. For example, the DC-DC converter 1150 may include a first damping circuit 1180 and a second damping circuit 1190. For example, the first damping circuit 1180 may be disposed in parallel with the first inductor 1161 Lᵣ₁. For example, the first damping circuit 1180 may include a damping capacitor 1181 and a damping resistor 1182. However, the present disclosure is not limited thereto. For example, the first damping circuit 1180 may include the damping capacitor 1181. For example, the second damping circuit 1190 may be disposed in parallel with the second inductor 1171 Lᵣ₂. For example, the second damping circuit 1190 may include a damping capacitor 1191 and a damping resistor 1192. However, the present disclosure is not limited thereto. For example, the second damping circuit 1189 may include the damping capacitor 1191.

According to an embodiment, the first damping circuit 1180 and the second damping circuit 1190 may be used to prevent an increase in an output voltage of the DC-DC converter 1150 in a no load or light load situation. For example, as parasitic capacitors of transistors Q5, Q6, Q7, and Q8 in the second portion 462 operate as if being connected in parallel with the first inductor 1161 Lᵣ₁ and the second inductor 1171 Lᵣ₂, the output voltage may increase without being regulated. The first damping circuit 1180 disposed in parallel with the first inductor 1161Lᵣ₁ (or the second damping circuit 1190 disposed in parallel with the second inductor 1171 Lᵣ₂) may remove an influence by the parasitic capacitors. Accordingly, the regulation of the output voltage may be performed in the no load or light load situation.

A control circuit according to the present disclosure and an electronic device including the same may use a PWM controller (e.g., the PWM controller 500) and an additional circuit (e.g., the switching circuit 610 of FIG. 6, the voltage dividing circuit 710 of FIG. 7, the discharging circuit 810 of FIG. 8, the first protection circuit 910 of FIG. 9A, or the second protection circuit 960 of FIG. 9B) connected to the PWM controller, or an additional circuit in a DC-DC converter (e.g., the damping circuit 1120 of FIG. 11A, or the first damping circuit 1180 and the second damping circuit 1190 of FIG. 11B) connected to the PWM controller. The control circuit according to the present disclosure and the electronic device including the same may use a PWM controller (e.g., the PWM controller 500) in which PFM control is implemented to perform modulation of a switching frequency in the start-up interval by adding an additional circuit to the control circuit or the electronic device 300. In addition, the control circuit according to the present disclosure and the electronic device including the same may reduce a stress of elements in the DC-DC converter in which the PWM controller is used by adding an additional circuit to the control circuit or the electronic device 300. Accordingly, the control circuit according to the present disclosure and the electronic device including the same may reduce a production cost and reduce a size of the electronic device by using the additional circuit having a relatively simple configuration.

The effects that can be obtained from the present disclosure are not limited to those described above, and any other effects not mentioned herein will be clearly understood by those having ordinary knowledge in the art to which the present disclosure belongs, from the following description.

As described above, a control circuit for a direct current (DC)-DC converter may comprise a pulse width modulation (PWM) controller for generating a PWM signal applied to a gate of a transistor in the DC-DC converter. The control circuit may comprise a lumped element connected to an adjusting pin of the PWM controller for adjusting a switching frequency of the PWM signal controlling a time when the gate is driven. The control circuit may comprise a first resistor to which a driving voltage of the PWM controller is applied. The control circuit may comprise a diode connected to the first resistor. The control circuit may comprise a capacitor and a second resistor for discharging of the capacitor that are disposed in parallel between the diode and the adjusting pin.

According to an embodiment, the switching frequency of the PWM signal may be decreased in accordance with the capacitor being charged by the driving voltage in a start-up interval of the PWM controller in accordance with the first resistor and the capacitor. The switching frequency of the PWM signal may be adjusted in accordance with the lumped element in a steady state interval after the start-up interval. The time when the gate is driven may be increased in accordance with the switching frequency decreasing in the start-up interval. A length of the start-up interval may be determined based on resistance of the first resistor and capacitance of the capacitor.

According to an embodiment, the first resistor may be connected to an anode of the diode. Each of the second resistor and the capacitor may be connected to a cathode of the diode. The lumped element may comprise at least one of a resistor or a capacitor.

According to an embodiment, the control circuit may further comprise a discharging circuit. The discharging circuit may comprise a first transistor comprising a drain to which the driving voltage is applied. The discharging circuit may comprise a second transistor comprising a gate connected to the drain of the first transistor, the gate of the second transistor to which the driving voltage is applied. The discharging circuit may comprise a resistor connecting between a drain of the second transistor and the capacitor.

According to an embodiment, the discharging circuit may be used to discharge the capacitor charged by the driving voltage during the start-up interval in a fault state of the PWM controller. The PMW controller may further comprise a controlling pin for a duty of the PWM signal in the start-up interval. A gate of the first transistor of the discharging circuit may be connected to the controlling pin.

According to an embodiment, the control circuit may further comprises a first protection circuit. The first protection circuit may comprise a diode connected to the controlling pin. The first protection circuit may comprise a transistor comprising a gate connected to the controlling pin and a drain to which the driving voltage is applied. The first protection circuit may comprise a capacitor connected to a source of the transistor of the first protection circuit and connected to the diode of the first protection circuit. The first protection circuit may be used to provide energy to the controlling pin through discharging of the capacitor of the first protection circuit charged during the start-up interval while a voltage applied to the controlling pin of the PWM controller is decreased.

According to an embodiment, the PWM controller may further comprise a current detecting pin for over current protection (OCP). The control circuit may further comprise a second protection circuit. The second protection circuit may comprise a protecting resistor disposed in parallel with an input resistor connected to an input end of an amplifier comprising an output end connected to the current detecting pin. The second protection circuit may comprise a protecting transistor comprising a drain connected to the protecting resistor, and a gate connected to the gate of the second transistor of the discharging circuit and the drain of the first transistor of the discharging circuit. The second protection circuit may be used to increase a gain of the amplifier based on the input resistor and an output resistor between the input end and the output end of the amplifier in the start-up interval.

According to an embodiment, the control circuit may further comprise a duty resistor connected to the controlling pin and a duty capacitor connected to the duty resistor.

According to an embodiment, the PWM controller may further comprise a current detecting pin for over current protection (OCP). The control circuit may further comprise a voltage dividing circuit. The voltage dividing circuit may comprise a first dividing resistor to which an input voltage of the DC-DC converter is applied. The voltage dividing circuit may comprise a second dividing resistor connected to a ground and the first dividing resistor. The voltage dividing circuit may comprise a third dividing resistor connected to the first dividing resistor, the second dividing resistor, and the current detecting pin. The voltage dividing circuit may be used to adjust a threshold voltage for the OCP of the PWM controller using the input voltage of the DC-DC converter.

According to an embodiment, the DC-DC converter may comprise an LLC converter. The LLC converter may comprise a transformer. The LLC converter may comprise an inductor disposed in series with the transformer. The LLC converter may comprise a damping circuit disposed in parallel with the inductor. The damping circuit may comprise a resistor and a capacitor.

According to an embodiment, the DC-DC converter may comprise a cap-isolation converter. The cap-isolation converter may comprise a first transforming circuit comprising a first inductor and a first capacitor disposed in series with the first inductor. The cap-isolation converter may comprise a second transforming circuit comprising a second inductor and a second capacitor disposed in series with the second inductor. The cap-isolation converter may comprise a damping circuit disposed in parallel with each of the first inductor and the second inductor. The damping circuit may comprise a resistor and a capacitor.

According to an embodiment, the DC-DC converter may comprise a first set of transistors and a second set of transistors. The PWM controller may be connected to a gate of each of the first set of transistors and a gate of each of the second set of transistors. The PWM signal output by the PWM controller may selectively switch one of the first set and the second set.

According to an embodiment, the DC-DC converter may comprise a first stage for converting an input voltage of the DC-DC converter comprising the first set of transistors and the second set of transistors. The DC-DC converter may comprise second stages for providing radio frequency (RF) circuits with the input voltage converted from the first stage. The second stages may be disposed in parallel with each other.

According to an embodiment, the PWM controller may comprise a plurality of outputting pins. The PWM controller may further comprise a pin for adjusting a dead-time between PWM signals output from the plurality of outputting pins.

As described above, an electronic device may comprise a direct current (DC)-DC converter. The electronic device may comprise an electronic component to which a voltage converted by the DC-DC converter is applied. The electronic device may comprise a pulse width modulation (PWM) controller for generating a PWM signal applied to a gate of a transistor in the DC-DC converter. The electronic device may comprise a lumped element connected to an adjusting pin of the PWM controller for adjusting a switching frequency of the PWM signal controlling a time when the gate is driven. The electronic device may comprise a first resistor to which a driving voltage of the PWM controller is applied. The electronic device may comprise a diode connected to the first resistor. The electronic device may comprise a capacitor and a second resistor for discharging of the capacitor that are disposed in parallel between the diode and the adjusting pin.

According to an embodiment, the electronic component may comprise a radio frequency (RF) component. The RF component may comprise at least one of a power amplifier or a radio frequency integrated circuit (RFIC).

According to an embodiment, the switching frequency of the PWM signal may be decreased in accordance with the capacitor being charged by the driving voltage in a start-up interval of the PWM controller in accordance with the first resistor and the capacitor. The switching frequency of the PWM signal may be adjusted in accordance with the lumped element in a steady state interval after the start-up interval. The time when the gate is driven may be increased in accordance with the switching frequency decreasing in the start-up interval. A length of the start-up interval may be determined based on resistance of the first resistor and capacitance of the capacitor.

According to an embodiment, the first resistor may be connected to an anode of the diode. Each of the second resistor and the capacitor may be connected to a cathode of the diode. The lumped element may comprise at least one of a resistor or a capacitor.

According to an embodiment, the electronic device may further comprise a discharging circuit connected to the PWM controller. The discharging circuit may comprise a first transistor comprising a drain to which the driving voltage is applied. The discharging circuit may comprise a second transistor comprising a gate connected to the drain of the first transistor, the gate of the second transistor to which the driving voltage is applied. The discharging circuit may comprise a resistor connecting between a drain of the second transistor and the capacitor.

According to an embodiment, the discharging circuit may be used to discharge the capacitor charged by the driving voltage during the start-up interval in a fault state of the PWM controller. The PMW controller may further comprise a controlling pin for a duty of the PWM signal in the start-up interval. A gate of the first transistor of the discharging circuit may be connected to the controlling pin.

Methods according to embodiments described in claims or specifications of the present disclosure may be implemented as a form of hardware, software, or a combination of hardware and software.

In a case of implementing as software, a computer-readable storage medium for storing one or more programs (software module) may be provided. The one or more programs stored in the computer-readable storage medium are configured for execution by one or more processors in an electronic device. The one or more programs include instructions that cause the electronic device to execute the methods according to embodiments described in claims or specifications of the present disclosure. The one or more programs may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. In the case of being distributed online, at least part of the computer program product may be temporarily generated or at least temporarily stored in the machine-readable storage medium, such as memory of the manufacturer's server, the application store's server, or a relay server.

Such a program (software module, software) may be stored in a random access memory, a non-volatile memory including a flash memory, a read only memory (ROM), an electrically erasable programmable read only memory (EEPROM), a magnetic disc storage device, an optical storage device (e.g., a compact disc-ROM (CD-ROM), digital versatile discs (DVDs), or other formats), or a magnetic cassette. Alternatively, it may be stored in memory configured with a combination of some or all of them. In addition, a plurality of configuration memories may be included.

Additionally, a program may be stored in an attachable storage device that may be accessed through a communication network such as the Internet, Intranet, local area network (LAN), wide area network (WAN), or storage area network (SAN), or a combination thereof. Such a storage device may be connected to a device performing an embodiment of the present disclosure through an external port. In addition, a separate storage device on the communication network may also be connected to a device performing an embodiment of the present disclosure.

In the above-described specific embodiments of the present disclosure, components included in the disclosure are expressed in the singular or plural according to the presented specific embodiment. However, the singular or plural expression is selected appropriately according to a situation presented for convenience of explanation, and the present disclosure is not limited to the singular or plural component, and even components expressed in the plural may be configured in the singular, or a component expressed in the singular may be configured in the plural.

According to various embodiments, one or more components or operations of the above-described components may be omitted, or one or more other components or operations may be added. Alternatively or additionally, a plurality of components (e.g., modules or programs) may be integrated into a single component. In such a case, the integrated component may still perform one or more functions of each of the plurality of components in the same or similar manner as they are performed by a corresponding one of the plurality of components before the integration. According to various embodiments, operations performed by the module, the program, or another component may be executed sequentially, in parallel, repeatedly, or heuristically, or one or more of the operations may be executed in a different order or omitted, or one or more other operations may be added.

Meanwhile, specific embodiments have been described in the detailed description of the present disclosure, and of course, various modifications are possible without departing from the scope of the present disclosure.

## Claims

1. A control circuit for a direct current (DC)-DC converter comprising:
a pulse width modulation (PWM) controller for generating a PWM signal applied to a gate of a transistor in the DC-DC converter;
a lumped element connected to an adjusting pin of the PWM controller for adjusting a switching frequency of the PWM signal controlling a time when the gate is driven;
a first resistor to which a driving voltage of the PWM controller is applied;
a diode connected to the first resistor; and
a capacitor and a second resistor for discharging of the capacitor that are disposed in parallel between the diode and the adjusting pin.

2. The control circuit of claim 1,
wherein the switching frequency of the PWM signal is:
decreased in accordance with the capacitor being charging by the driving voltage in a start-up interval of the PWM controller in accordance with the first resistor and the capacitor, and
adjusted in accordance with the lumped element in a steady state interval after the start-up interval,
wherein the time when the gate is driven is increased in accordance with the switching frequency being decreasing in the start-up interval, and
wherein a length of the start-up interval is determined based on resistance of the first resistor and capacitance of the capacitor.

3. The control circuit of claim 1,
wherein the first resistor is connected to an anode of the diode,
wherein each of the second resistor and the capacitor is connected to a cathode of the diode, and
wherein the lumped element comprises at least one of a resistor or a capacitor.

4. The control circuit of claim 1,
wherein the control circuit further comprises a discharging circuit,
wherein the discharging circuit comprises:
a first transistor comprising a drain to which the driving voltage is applied;
a second transistor comprising a gate connected to the drain of the first transistor, the gate of the second transistor to which the driving voltage is applied; and
a resistor connecting between a drain of the second transistor and the capacitor.

5. The control circuit of claim 4,
wherein the discharging circuit is used to discharge the capacitor charged by the driving voltage during the start-up interval in a fault state of the PWM controller,
wherein the PMW controller further comprises a controlling pin for a duty of the PWM signal in the start-up interval, and
wherein a gate of the first transistor of the discharging circuit is connected to the controlling pin.

6. The control circuit of claim 5,
wherein the control circuit further comprises a first protection circuit,
wherein the first protection circuit comprises:
a diode connected to the controlling pin;
a transistor comprising a gate connected to the controlling pin and a drain to which the driving voltage is applied; and
a capacitor connected to a source of the transistor of the first protection circuit and connected to the diode of the first protection circuit,
wherein the first protection circuit is used to provide energy to the controlling pin through discharging of the capacitor of the first protection circuit charged during the start-up interval while a voltage applied to the controlling pin of the PWM controller is decreased.

7. The control circuit of claim 5,
wherein the PWM controller further comprises a current detecting pin for over current protection (OCP),
wherein the control circuit further comprises a second protection circuit,
wherein the second protection circuit comprises:
a protecting resistor disposed in parallel with an input resistor connected to an input end of an amplifier comprising an output end connected to the current detecting pin; and
a protecting transistor comprising a drain connected to the protecting resistor, and a gate connected to the gate of the second transistor of the discharging circuit and the drain of the first transistor of the discharging circuit,
wherein the second protection circuit is used to increase a gain of the amplifier based on the input resistor and an output resistor between the input end and the output end of the amplifier in the start-up interval.

8. The control circuit of claim 5,
wherein the control circuit further comprises a duty resistor connected to the controlling pin and a duty capacitor connected to the duty resistor.

9. The control circuit of claim 1,
wherein the PWM controller further comprises a current detecting pin for over current protection (OCP),
wherein the control circuit further comprises a voltage dividing circuit,
wherein the voltage dividing circuit comprises:
a first dividing resistor to which an input voltage of the DC-DC converter is applied;
a second dividing resistor connected to a ground and the first dividing resistor; and
a third dividing resistor connected to the first dividing resistor, the second dividing resistor, and the current detecting pin,
wherein the voltage dividing circuit is used to adjust a threshold voltage for the OCP of the PWM controller using the input voltage of the DC-DC converter.

10. The control circuit of claim 1,
wherein the DC-DC converter comprises an LLC converter,
wherein the LLC converter comprises:
a transformer;
an inductor disposed in series with the transformer; and
a damping circuit disposed in parallel with the inductor,
wherein the damping circuit comprises a resistor and a capacitor.

11. The control circuit of claim 1,
wherein the DC-DC converter comprises a cap-isolation converter,
wherein the cap-isolation converter comprises:
a first transforming circuit comprising a first inductor and a first capacitor disposed in series with the first inductor;
a second transforming circuit comprising a second inductor and a second capacitor disposed in series with the second inductor; and
a damping circuit disposed in parallel with each of the first inductor and the second inductor,
wherein the damping circuit comprises a resistor and a capacitor.

12. The control circuit of claim 1,
wherein the DC-DC converter comprises a first set of transistors and a second set of transistors,
wherein the PWM controller is connected to a gate of each of the first set of transistors and a gate of each of the second set of transistors, and
wherein the PWM signal output by the PWM controller selectively switches one of the first set and the second set.

13. The control circuit of claim 12,
wherein the DC-DC converter comprises:
a first stage for converting an input voltage of the DC-DC converter comprising the first set of transistors and the second set of transistors; and
second stages for providing radio frequency (RF) circuits the input voltage converted from the first stage, and
wherein the second stages are disposed in parallel with each other.

14. The control circuit of claim 1,
wherein the PWM controller further comprises:
a plurality of outputting pins; and
a pin for adjusting a dead-time between PWM signals output from the plurality of outputting pins.

15. An electronic device comprising:
a direct current (DC)-DC converter;
an electronic component to which a voltage converted by the DC-DC converter is applied;
a pulse width modulation (PWM) controller for generating a PWM signal applied to a gate of a transistor in the DC-DC converter;
a lumped element connected to a adjusting pin of the PWM controller for adjusting a switching frequency of the PWM signal controlling a time when the gate is driven;
a first resistor to which a driving voltage of the PWM controller is applied;
a diode connected to the first resistor; and
a capacitor and a second resistor for discharging of the capacitor that are disposed in parallel between the diode and the adjusting pin.
